# EUROPÄISCHE PATENTSCHRIFT

(11) **EP 3 531 806 B1**
(45) Veröffentlichungstag und Bekanntmachung des Hinweises auf die Patenterteilung: **25.03.2020**
(21) Anmeldenummer: 18158657.9
(22) Anmeldetag: 26.02.2018
(51) Int. Cl.: H05K 3/00, H05K 1/02, H05K 7/20, H05K 1/14, H05K 1/18

(54) **ELEKTRONISCHE LEITERPLATTENBAUGRUPPE FÜR HOCHLEISTUNGSBAUTEILE**
ELECTRONIC COMPONENT BOARD ASSEMBLY FOR HIGH PERFORMANCE COMPONENTS
ENSEMBLE DE CARTES DE CIRCUITS IMPRIMÉS POUR COMPOSANTS ÉLECTRONIQUES À HAUTE PERFORMANCE

(43) Veröffentlichungstag der Anmeldung: 28.08.2019
(73) Patentinhaber: ZKW Group GmbH, 3250 Wieselburg (AT)
(72) Erfinder: Kieslinger, Dietmar, 2604 Theresienfeld (AT); Manhart, Wolfgang, 83679 Sachsenkam (DE); Edlinger, Erik, 1090 Wien (AT); Lahner, Markus, 3100 St. Pölten (AT)
(74) Vertreter: Patentanwaltskanzlei Matschnig & Forsthuber OG

(56) Entgegenhaltungen:
- DE-A1-102006 016 775
- DE-A1-102016 209 611
- GB-A- 2 396 056
- US-A1- 2013 062 717

## Beschreibung

Die Erfindung betrifft ein elektronisches Modul umfassend zumindest eine, gegebenenfalls beidseitig bestückte, Leiterplatte einer ersten Gattung (als "Leiterplatte A" bezeichnet), die in überlappender Weise mit zumindest einer Leiterplatte einer zweiten Gattung (als "Leiterplatte B" bezeichnet) bestückt ist, wobei die Leiterplatte B mit zumindest einem elektronischen Bauteil mit spezifischen Anforderungen bestückt ist, und die miteinander verbundenen Leiterplatten A und B einen gestuften Leiterplattenverbund bilden, wobei der gestufte Leiterplattenverbund zumindest bereichsweise durch Endbereiche, welche durch Abschnitte der zumindest einen Leiterplatte A gebildet werden, begrenzt ist, und der gestufte Leiterplattenverbund auf einem Kühlkörper aufgesetzt ist, wobei eine Befestigungsseite der zumindest einen Leiterplatte B flächig auf einer Auflagefläche des Kühlkörpers aufliegt.

Die Erfindung betrifft außerdem ein Verfahren zur Herstellung eines elektronischen Moduls gemäß der Erfindung in einer Bauteilbestückungslinie, wobei das elektronische Modul einen gestuften Leiterplattenverbund mit zumindest einem elektronischen Bauteil mit spezifischen Anforderungen und einen Kühlkörper umfasst.

Leiterplatten sind im Stand der Technik auch als printed circuit boards (PCB) oder printed wiring boards (PWB) bekannt und dienen dazu, elektrische, vor allem jedoch elektronische Komponenten platzsparend und stabil miteinander zu verbinden. Zu diesem Zweck weisen Leiterplatten auf isolierenden Schichten angeordnete leitende Schichten auf, die zur Verschaltung der Komponenten zu Leiterbahnen strukturiert sind und von den isolierenden Schichten voneinander getrennt sind. Die Komponenten können hierbei auf der Oberfläche der Leiterplatte angeordnet oder in die Leiterplatte eingebettet sein. Die fortschreitende Miniaturisierung von Leiterplatten zur Bereitstellung einer großen Zahl von Funktionalitäten in kleinbauenden Geräten führt zu nicht unerheblichen Zwängen hinsichtlich der Ableitung von Wärme, die von den Komponenten abgegeben wird und die sowohl zum Schutz der Komponenten als auch zum Schutz der Leiterplatte effizient abgeleitet und abgestrahlt werden muss. Besonders problematisch sind Hochleistungsbauteile wie beispielsweise Komponenten, die besonders viel Wärme abgeben; so erfordern beispielsweise Leistungstransistoren und LEDs (light-emitting diodes), die in der Kraftfahrzeuglichttechnik zunehmend Verwendung finden, ein durchdachtes Wärmemanagement der Leiterplatte, um Überhitzung und damit einhergehend Beschädigungen der Leiterplatten oder der Bauelemente zu vermeiden.

Beispielsweise kommen für Hochleistungsbauteile, z.B. thermisch kritische Bauteile wie Leistungstransistoren und LEDs, IMS-Leiterplatten zum Einsatz. Die notwendige thermisch relevante Fläche ist aber meist deutlich kleiner als die Fläche der letztendlich produzierten IMS-Flachbaugruppe. Dies liegt insbesondere daran, dass zwischen den einzelnen elektronischen Baukomponenten ein Minimalabstand notwendig ist, z.B. bei LEDs aufgrund der lichttechnischen Anforderungen. Aus Gründen der einfachen und toleranzstabilen Montage ist es jedoch zweckmäßig, wenn alle LEDs auf einer Leiterplatte sitzen. Außerdem befinden sich Stecker und Kontaktierungen aus konstruktiven Gründen in einem gewissen Abstand zum Hochleistungsbauteil auf der Leiterplatte. Ferner dient die Leiterplatte auch häufig als konstruktives Bauteil, an dem neben dem Hochleistungsbauteil andere Komponenten ausgerichtet und befestigt werden (z.B. optische Bauteile wie Reflektoren oder Primäroptiken bei LED-Baugruppen für Kraftfahrzeugbeleuchtungseinrichtungen); Diese Ausricht- und Befestigungspunkte liegen zwangsweise in einer bestimmten Entfernung zum Hochleistungsbauteil. All diese Gründe führen zu IMS-Leiterplattenabmessungen, die deutlich größer sind als sie aus thermischen Gründen sein müssten. Diese Zusatzfläche bei IMS-Leiterplatten auszuführen bedeutet Verschwendung von teurem Material.

Es gibt Ansätze von Leiterplattenherstellern, Leiterplatten für Hochleistungsbauteile (z.B. IMS-Leiterplatten) in kostengünstigere Leiterplatten bzw. Leiterplatten mit anderen Eigenschaften (z.B. in klassische FR4 Multilayer-Leiterplatten), zu integrieren. Ein Ansatz verfolgt z.B. das Ziel, eine hybride FR4/IMS-Kombinationsleiterplatte zu erhalten, die einerseits das Wärmeableitverhalten der IMS-Leiterplatte und gleichzeitig die Flexibilität, Auflösung und Multi-Layer-Fähigkeit von FR4-Leiterplatten hat. Die bisher bekannten Lösungen sind jedoch preislich nicht attraktiv, mit fertigungstechnischen Einschränkungen bezüglich der Form und Größe des IMS-Anteils verbunden oder die erhaltenen elektronischen Module basierend auf hybriden Leiterplatten sind mechanisch nicht stabil genug, um als einzige starre, klassische Flachbaugruppe im weiteren Verarbeitungsprozess (Assemblierung, Montage etc.) verwendet zu werden.
Ein elektronisches Modul gemäß des Oberbegriffs von Anspruch 1 ist aus dem Dokument DE-A1-102016209611 bekannt

Es ist daher eine Aufgabe der Erfindung, die oben genannten Nachteile zu beseitigen und ein elektronisches Modul bereitzustellen, welches einerseits alle Voraussetzungen für Hochleistungsbauteile erfüllt, andererseits teures, für Hochleistungsbauteile notwendiges Leiterplattenmaterial nur im benötigten Ausmaß enthält, in einem standardmäßigen Bestückungsvorgang, z.B. in einem SMT (surface mounted technology)-Bestückungsvorgang, produziert und in der Weiterverarbeitung bzw. Montage wie eine einzige, starre, klassische Flachbaugruppe gehandhabt werden kann.

Diese Aufgabe wird durch Bereitstellen eines elektronischen Moduls wie eingangs genannt dadurch gelöst, dass erfindungsgemäß die Auflagefläche des Kühlkörpers so dimensioniert und positioniert ist, dass sie sich zumindest teilweise lateral über die Befestigungsseite der zumindest einen Leiterplatte B hinaus jeweils in Richtung der durch die Abschnitte der zumindest einen Leiterplatte A gebildeten Endbereiche erstreckt, und dass auf der Auflagefläche des Kühlkörpers Stützelemente zur mechanischen Stützung der durch die Abschnitte der zumindest einen Leiterplatte A gebildeten Endbereiche ausgebildet sind.

Diese Aufgabe wird ferner durch ein Verfahren zur Herstellung eines elektronischen Moduls in einer Bauteilbestückungslinie gelöst, das elektronische Modul umfassend einen gestuften Leiterplattenverbund mit zumindest einem elektronischen Bauteil mit spezifischen Anforderungen und einen Kühlkörper, wobei das Verfahren umfasst:
- Bestücken zumindest einer, gegebenenfalls beidseitig bestückten oder zu bestückenden, Leiterplatte einer ersten Gattung (als "Leiterplatte A" bezeichnet) in überlappender Weise mit zumindest einer Leiterplatte einer zweiten Gattung (als "Leiterplatte B" bezeichnet), wobei die Leiterplatte B mit zumindest einem elektronischen Bauteil mit spezifischen Anforderungen bestückt ist oder bestückt wird, zum Erhalt eines gestuften Leiterplattenverbunds, wobei der gestufte Leiterplattenverbund zumindest bereichsweise durch Endbereiche, welche durch Abschnitte der zumindest einen Leiterplatte A gebildet werden, begrenzt wird, und
- Aufsetzen des erhaltenen gestuften Leiterplattenverbunds auf den Kühlkörper derart, dass eine Befestigungsseite der zumindest einen Leiterplatte B flächig auf einer Auflagefläche des Kühlkörpers aufliegt, wobei die Auflagefläche des Kühlkörpers so dimensioniert und positioniert wird, dass sie sich zumindest teilweise lateral über die Befestigungsseite der zumindest einen Leiterplatte B hinaus jeweils in Richtung der durch die Abschnitte der zumindest einen Leiterplatte A gebildeten Endbereiche erstreckt, und wobei auf der Auflagefläche des Kühlkörpers Stützelemente zur mechanischen Stützung der durch die Abschnitte der zumindest einen Leiterplatte A gebildeten Endbereiche ausgebildet sind.

Dank der Erfindung wird ein elektronisches Modul mit einem hybriden Leiterplattenverbund geschaffen, das einerseits für Hochleistungsbauteile geeignet ist, das zumeist teure, für Hochleistungsbauteile notwendige Leiterplattenmaterial nur im tatsächlich benötigten Ausmaß enthält und somit kostenoptimiert ist, und andererseits mechanisch so stabil ist, dass es in der Weiterverarbeitung (z.B. Assemblierung, Montage, Fertigung) wie eine einzige, starre, klassische Flachbaugruppe gehandhabt werden kann. Es können somit die Vorteile von zwei verschiedenen Arten von Leiterplatten genutzt werden, ohne auf den Vorteil der einfachen Handhabung klassischer Flachbaugruppen verzichten zu müssen: beispielsweise können auf für viele Standardanwendungen verwendeten, kostengünstigen FR4-Leiterplatten komplexe Schaltungen und Designs realisiert werden, wohingegen für Anwendungen im Hochfrequenzbereich thermische und/oder elektrische Voraussetzungen im Vordergrund stehen, die durch die weitere Leiterplattengattung erfüllt werden. Dank der Erfindung ist z.B. eine enge Integration von Steuerelektronik (z.B. Kontakte auf einer FR4-Leiterplatte) und einem Hochleistungsbauteil (z.B. eine thermisch kritische LED auf einer IMS-Leiterplatte) auf einem einzigen mechanisch stabilen Modul möglich. Das elektronische Modul lässt sich außerdem einfach in einem bestehenden SMT-Prozess bzw. in einer gängigen SMT-Bauteilbestückungslinie für doppelseitig bestückte Baugruppen herstellen. Aufgrund des geringeren Metallanteils ist das elektronische Modul gemäß der Erfindung zudem leichter.

Der hierin synonym verwendeten Begriffe "elektronisches Bauteil mit spezifischen Anforderungen" und "Hochleistungsbauteil" beziehen sich dabei auf Bauteile, die spezifische Anforderungen hinsichtlich der Leiterplatte bzw. dem Leiterplattensubstrat (hierin als "Leiterplatte B" bezeichnet), auf der sie fixiert werden, haben. Wie oben in der Einleitung bereits erwähnt, kann es sich hierbei zum Beispiel um Bauteile handeln, die sehr viel Wärme produzieren (z.B. LEDs) und daher eine Leiterplatte mit hohem Wärmeableitvermögen (z.B. IMS-Leiterplatte) oder mit entsprechender Anpassung an die Wärmeausdehnung benötigen. Einem Fachmann auf dem Gebiet sind die unterschiedlichen Basismaterialien für Leiterplatten und deren Eigenschaften sowie die Anforderungen der Leiterplatteneigenschaften für die jeweiligen Hochleistungsbauteile hinlänglich bekannt. Beispielsweise sind unter den Internetlinks http://www.contag.de/uploads/pi_ti/materialien_b.pdf und http://wiki.fe.de/index.php/Basismaterialarten umfangreiche Informationen zu Leiterplatten-Basismaterialien und korrespondierenden Hochleistungsbauteilen zu entnehmen. Repräsentative Beispiele für dem Fachmann bekannte Hochleistungsbauteile aus dem Kraftfahrzeugbeleuchtungstechnikbereich samt zugehörigen Leiterplatten und einer Begründung sind in der folgenden Tabelle 1 wiedergegeben:

**Tabelle 1:**

| **Hochleistungsbauteil** | **Leiterplattenmaterial** | **Begründung** |
|---|---|---|
| Leistungstransistor | Al-IMS | Entwärmung, kostengünstiger als Cu-IMS |
| HF/Prozessor | HDI-FR4 | Integrationsdichte |
| High-Power LED (Keramik-Package) | Cu-IMS | Entwärmung, geringere Fehlanpassung bei Wärmeausdehung (CTE) als bei Al-IMS |
| Halbleiterlaser | Keramik | Exakte Anpassung bei Wärmeausdehnung (CTE-Anpassung), hohe Wärmeleitfähigkeit, hohe Lebensdauer und Zuverlässigkeit |
| Mikrowellenverstärker (Radar) | PTFE (Teflon®) | Hochfrequenzeigenschaften |
| Ventile, Pumpen, Messkanäle, Entlüftungen | Mikrofluidische Leiterplatten, z.B. ALine, Elveflow | Integration Chemie/Optik/Elektronik |

Bei einer Variante kann es sich bei der Leiterplatte A um eine FR4-Leiterplatte handeln. Bei einer anderen Variante kann es sich bei der Leiterplatte B um eine IMS-Leiterplatte (Metallkernleiterplatte) handeln. Bei einer spezifischen Variante kann es sich bei der Leiterplatte A um eine FR4-Leiterplatte und bei der Leiterplatte B um eine IMS-Leiterplatte (Metallkernleiterplatte) handeln.

Das elektronische Bauteil mit spezifischen Anforderungen kann insbesondere ein optoelektronisches Bauteil sein. Das optoelektronische Bauteil kann beispielsweise eine Laserdiode, eine LED, eine LED-Anordnung, eine Photodiode oder ein DLP-Bauteil sein.

Das Verfahren zur Herstellung des elektronischen Moduls kann in einer SMT (surface mounted technology)-Bauteilbestückungslinie durchgeführt werden.

Bei einer Variante ist die Auflagefläche des Kühlkörpers so dimensioniert und positioniert, dass sie sich im Wesentlichen bis zu den durch die Abschnitte der zumindest einen Leiterplatte A gebildeten Endbereichen erstreckt. Die Endbereiche der Auflagefläche des Kühlkörpers und die Endbereiche der Leiterplatte A können zumindest bereichsweise miteinander fluchten. Bei einer Weiterbildung der Erfindung können die Auflagefläche des Kühlkörpers und die Fläche des gestuften Leiterplattenverbunds hinsichtlich ihrer Flächenform und Flächenausdehnung im Wesentlichen deckungsgleich sein.

Bei einfach zu realisierenden Varianten weist die zumindest eine Leiterplatte A zumindest eine Ausnehmung auf und die zumindest eine Leiterplatte B ist in überlappender Weise derart mit der zumindest einen Leiterplatte A verbunden, dass jeweils eine Leiterplatte B jeweils eine Ausnehmung der Leiterplatte A zumindest bereichsweise, vorzugsweise vollständig, überdeckt.

Vorzugsweise ist die zumindest eine Ausnehmung im Wesentlichen fensterförmig, d.h. die Umrandung der Ausnehmung wird gänzlich durch die Leiterplatte A begrenzt. Die Form der fensterförmigen Ausnehmung ist frei wählbar und kann beispielsweise quadratisch, rechteckig, viereckig, rund, abgerundet etc. sein. Typischerweise ist die Ausnehmung jedoch rechteckig oder quadratisch. Bei dieser Untervariante wird ein mechanisch besonders stabiles elektronisches Modul erhalten. Zudem lassen sich die Leiterplatten A und B in vielfältiger Weise miteinander kontaktieren und ermöglichen komplexe Designs und Kontaktierungen.

Bei einer Variante weist die zumindest eine Leiterplatte A genau eine Ausnehmung auf, wobei genau eine Leiterplatte B in überlappender Weise derart mit einer der zumindest einen Leiterplatte A verbunden wird, dass die Leiterplatte B die Ausnehmung der Leiterplatte A zumindest bereichsweise, vorzugsweise vollständig, überdeckt. Vorzugsweise überdeckt die Leiterplatte B die Ausnehmung der Leiterplatte A vollständig. Vorzugsweise weist der gestufte Leiterplattenverbund genau eine Leiterplatte A mit genau einer Ausnehmung auf, wobei genau eine Leiterplatte B in überlappender Weite mit der Leiterplatte A in einer Weise verbunden ist, dass die Leiterplatte B die Ausnehmung der Leiterplatte A vollständig überdeckt.

Beispielsweise wird die Leiterplatte A (z.B. eine FR4-Leiterplatte) mit der Leiterplatte B (z.B. eine IMS-Leiterplatte) so bestückt, dass die Leiterplatte B die fensterförmige Ausnehmung überdeckt und entlang der Begrenzungslinie der Ausnehmung mit der Leiterplatte A überlappt. Das auf der Leiterplatte B angeordnete Hochleistungsbauteil (z.B. eine LED-Anordnung) ist dabei so angeordnet und positioniert, dass es sich durch die Ausnehmung in der Leiterplatte A erstreckt (z.B. im Fall einer auf der Leiterplatte B fixierten LED-Anordnung strahlt die LED durch die Ausnehmung in der Leiterplatte A durch).

Bei bestimmten Varianten kann die (zumindest eine) Ausnehmung im Wesentlichen U-förmig sein. Bei spezifischen Varianten können zwei oder mehr voneinander beabstandete Leiterplatten A in überlappender Weise mit jeweils einer Leiterplatte B verbunden werden, so dass ein in Längsrichtung gestufter Leiterplattenverbund mit seriell alternierend verbundenen Leiterplatten A und B erhalten wird, wobei die zwei oder mehr Leiterplatten A im Wesentlichen in einer Ebene angeordnet sind und die Leiterplatte(n) B im Wesentlichen in einer Ebene angeordnet sind, wobei die Endbereiche des Leiterplattenverbunds durch einen Abschnitt einer jeweils endständigen Leiterplatte A gebildet werden. Diese beiden genannten Varianten stellen spezifische Ausgestaltungen dar, die bei speziellen Designs zur Anwendung kommen können. Die oben beschriebene Variante mit der fensterförmigen Ausnehmung wird jedoch bevorzugt, da damit ein mechanisch besonders stabiles elektronisches Modul erhalten wird und darüber hinaus lassen sich die Leiterplatten A und B in vielfältiger Weise miteinander kontaktieren und ermöglichen komplexe Designs und Kontaktierungen.

Die Stützelemente können auf der Auflagefläche des Kühlkörpers aufgebracht oder auf der Auflagefläche des Kühlkörpers, gegebenenfalls einstückig, angeformt sein, wobei die Stützelemente dazu eingerichtet sind, die durch die Abschnitte der zumindest einen Leiterplatte A gebildeten Endbereiche des Leiterplattenverbundes zu stützen.

Bei bestimmten Ausführungsvarianten können die Stützelemente mit einem "Gap Filler" in Form von strukturellem Klebstoff realisiert, der in Form von Klebepunkten auf der Auflagefläche des Kühlkörpers aufgebracht ist. Diese Klebepunkte stützen/ stabilisieren mechanisch die durch die Abschnitte der zumindest einen Leiterplatte A gebildeten Endbereiche des Leiterplattenverbundes. Diese Variante bietet sich zum Beispiel dann an, wenn an den Endbereichen der zumindest einen Leiterplatte A keine nennenswerten äußeren Kräfte angreifen und die zumindest eine Leiterplatte B (z.B. eine IMS-Leiterplatte) mit einem Klebemittel (z.B. einem thermisch leitfähigen Kleber) bereits mit ihrer Befestigungsfläche auf der Auflagefläche des Kühlkörpers befestigt ist.

Bei anderen Ausführungsvarianten können auf der Auflagefläche des Kühlkörpers im Bereich der Endbereiche des Leiterplattenverbunds Stufen als Stützelemente angeformt sein. Die Endbereiche des Leiterplattenverbunds sitzen auf diesen Stufen auf und werden mechanisch gestützt/ stabilisiert. Die Ausgestaltung der Stützelemente in Form von Stufen stellt dem Anschein nach eine einfache Lösung dar, hat aber den Nachteil, dass die Stufenhöhe genau auf den Bestückungsprozess (z.B. Lotpastendicke, Klebermenge, Schrumpfung beim Reflow-Löten etc.) abgestimmt werden muss. Die Umsetzung kann sich in der Praxis als schwierig herausstellen. Bei der Verwendung von Thermal Interface Materialien (TIM), wie z.B. bei Verwendung von thermisch leitfähigem Kleber (TIM-Kleber) zwischen der Leiterplatte B und dem Kühlkörper, muss zudem auch die TIM-Dicke in die Bestimmung der Stufenhöhe eingerechnet werden; diese Variante ist bei der Verwendung von TIM daher nur bedingt praxistauglich.

Bei besonders vorteilhaften Ausführungsvarianten sind im Bereich der durch die Abschnitte der zumindest einen Leiterplatte A gebildeten Endbereiche des Leiterplattenverbunds Beilagscheiben aus Leiterplatten B-Material als Stützelemente auf der Auflagefläche des Kühlkörpers aufgebracht, wobei die Endbereiche des Leiterplattenverbunds auf den Beilagscheiben aufsitzen und durch diese gestützt werden, und wobei das Leiterplatten B-Material für die Beilagscheiben aus derselben Charge gewählt ist, aus der das Leiterplatten B-Material für die zumindest eine Leiterplatte B stammt. Diese Variante hat den Vorteil, dass für die Beilagscheiben dieselbe Verbindungstechnik wie für die Leiterplatte B verwendet werden kann. Toleranzen in der Dicke der Leiterplatte B sowie Langzeit-Abweichungen im Bestückungsprozess lassen sich damit auf einfache Weise aufheben, da das Leiterplatten B-Material der Beilagscheiben aus derselben Charge wie das Leiterplatten B-Material der Leiterplatte B stammt.

Bei einer besonders vorteilhaften Weiterbildung der zuvor genannten Variante weist die zumindest eine Leiterplatte A Ausrichtungsbohrungen auf, und die Beilagscheiben sind unterhalb der Ausrichtungsbohrungen der zumindest einen Leiterplatte A auf der Auflagefläche des Kühlkörpers positioniert, so dass Oberflächenbereiche der jeweiligen Beilagscheiben durch die Ausrichtungsbohrungen freigelegt sind. Der Bestücker kann zwar für die laterale Positionierung nach an sich bekannter Art und Weise Passmarken/Löcher an der Leiterplatte A heranziehen, die z-Position ergibt sich jedoch aus der Oberfläche der Leiterplatte B, auf der das Hochleistungsbauteil positioniert ist. Alle Ausrichtungsbohrungen können auf der kostengünstigeren Leiterplatte A angeordnet sein, weshalb die kostenintensivere Leiterplatte B sehr klein gehalten werden kann. Ein wesentlicher Vorteil dieser Weiterbildung liegt zudem darin, dass eine exakte z-Referenzierung und somit eine hochpräzise Positionierung des zumindset einen Hochleistungsbauteils ermöglicht wird. Eine hochpräzise Positionierung ist besonders bei optoelektronischen Hochleistungsbauteilen, z.B. von LEDs, für lichttechnische Anwendungen, z.B. in Kraftfahrzeugscheinwerferanwendungen, von hoher Wichtigkeit. Die erreichbare Bestückgenauigkeit des hybriden gestuften Leiterplattenverbunds ist somit die gleiche wie bei "normalen" monolithischen Leiterplatten.

Bei bestimmten Ausführungsvarianten kann es vorgesehen sein, dass die Stützelemente dazu eingerichtet sind, thermische Energie von der zumindest einen Leiterplatte A an den Kühlkörper abzuführen und/oder einen Potentialausgleich zwischen der zumindest einen Leiterplatte A und dem Kühlkörper zu ermöglichen. Dies kann durch die Wahl entsprechender Materialien für die Stützelemente realisiert werden, z.B. durch thermisch und/oder elektrisch leitfähige Materialien wie Kupfer oder Aluminium.

Zur weiteren mechanischen Stabilisierung können die durch die Abschnitte der zumindest einen Leiterplatte A gebildeten Endbereiche des Leiterplattenverbunds auf den Stützelementen fixiert werden, z.B. durch Kleben.

Bei bestimmten Ausführungsformen sind die zumindest eine Leiterplatte A und die zumindest eine Leiterplatte B in deren Überlappungsbereich mittels Ball Grid Array (BGA)-Technik miteinander kontaktiert. Die BGA-Kontaktierungstechnik ist einem Fachmann auf dem Gebiet hinlänglich bekannt und ermöglicht eine höhere Anzahl von Anschlüssen und einen verbesserten Wärmetransport. Die in der BGA-Technik verwendeten Lotkugeln ("balls") können dabei nach an sich bekannter Weise an vorgesehen Kontaktpads auf einer der zu verbindenen Leiterplatten, zumeist auf der Leiterplatte B, aufgebracht werden. Alternativ können die Lotkugeln auch durch Aufrakeln von Lotpaste und anschließendes Schmelzen in einem Reflow-Prozess, wonach sich die Lotpaste beim Abkühlen zu Lotkugeln zusammenzieht, auf den Kontaktpads aufgebracht werden. Ein weiteres bekanntes Verfahren zum Aufbringen von Lotkugeln ist das einzelne Aufbringen von vorgefertigten BGA-Lotkugeln in einem Bestückungsautomaten mit Hilfe von Minidüsen auf die Kontaktpads der Leiterplatte.

Wie hierin beschrieben betrifft die Erfindung ein Verfahren zum Herstellen eines elektronischen Moduls gemäß der Erfindung. Bei einer ersten bevorzugten Variante des Verfahrens umfasst dieses die folgenden Schritte:
a) Bereitstellen zumindest einer Leiterplatte B mit einer Bestückungsseite (top) und einer der Bestückungsseite abgewandten Wärmeableitseite (bottom) sowie Bereitstellen von zumindest einem elektronischen Bauteil mit spezifischen Anforderungen,
b) Bestücken (top-up) und Fixieren des zumindest einen elektronischen Bauteils mit spezifischen Anforderungen auf der Bestückungsseite der zumindest einen Leiterplatte B und anschließend Wenden der Leiterplatte B,
c) Bereitstellen zumindest einer Leiterplatte A mit einer ersten Bestückungsseite (top) und einer der ersten Bestückungsseite abgewandten zweiten Bestückungsseite (bottom) sowie Bereitstellen von elektronischen Bauteilelementen,
d) Bestücken (top-up) und Fixieren von elektronischen Bauteilelementen auf der ersten Bestückungsseite der zumindest einen Leiterplatte A und anschließend Wenden der Leiterplatte A,
e) Bestücken (bottom-up) und Fixieren von elektronischen Bauteilelementen auf der zweiten Bestückungsseite der zumindest einen Leiterplatte A sowie Bestücken (bottom-up) und Fixieren der zumindest einen bestückten Leiterplatte B aus Schritt b) auf der zweiten Bestückungsseite der zumindest einen Leiterplatte A in überlappender Weise, zum Erhalt eines gestuften Leiterplattenverbunds, wobei der gestufte Leiterplattenverbund zumindest bereichsweise durch Endbereiche, welche durch Abschnitte der zumindest einen Leiterplatte A gebildet werden, begrenzt wird, und
f) Aufsetzen des erhaltenen gestuften Leiterplattenverbunds auf den Kühlkörper derart, dass die Wärmeableitseite der zumindest einen Leiterplatte B flächig auf einer Auflagefläche des Kühlkörpers aufliegt, wobei die Auflagefläche des Kühlkörpers so dimensioniert und positioniert wird, dass sie sich zumindest teilweise lateral über die Wärmeableitseite der zumindest einen Leiterplatte B hinaus jeweils in Richtung der durch die Abschnitte der zumindest einen Leiterplatte A gebildeten Endbereiche erstreckt, und auf der Auflagefläche des Kühlkörpers Stützelemente zur mechanischen Stützung der durch die Abschnitte der zumindest einen Leiterplatte A gebildeten Endbereiche ausgebildet sind.

Eine weitere, jedoch weniger bevorzugte, Variante des erfindungsgemäßen Verfahrens umfasst die folgenden Schritte:
g) Bereitstellen zumindest einer Leiterplatte A mit einer ersten Bestückungsseite (top) und einer der ersten Bestückungsseite abgewandten zweiten Bestückungsseite (bottom) sowie Bereitstellen von elektronischen Bauteilelementen,
h) Bestücken (bottom-up) und Fixieren von elektronischen Bauteilelementen auf der zweiten Bestückungsseite der zumindest einen Leiterplatte A,
i) Bereitstellen zumindest einer Leiterplatte B mit einer Bestückungsseite (top) und einer der Bestückungsseite abgewandten Wärmeableitseite (bottom),
j) Bestücken (bottom-up) und Fixieren der zumindest einen Leiterplatte B auf der zweiten Bestückungsseite der zumindest einen Leiterplatte A in überlappender Weise, zum Erhalt eines gestuften Leiterplattenverbunds, wobei der gestufte Leiterplattenverbund zumindest bereichsweise durch Endbereiche, welche durch Abschnitte der zumindest einen Leiterplatte A gebildet werden, begrenzt wird, und anschließend Wenden des gestuften Leiterplattenverbunds,
k) Bestücken (top-up) und Fixieren zumindest eines bereitgestellten elektronischen Bauteils mit spezifischen Anforderungen auf der Bestückungsseite der zumindest einen Leiterplatte B sowie von elektronischen Bauteilelementen auf der ersten Bestückungsseite der zumindest einen Leiterplatte B des gestuften Leiterplattenverbunds aus Schritt j), zum Erhalt eines beidseitig bestückten gestuften Leiterplattenverbunds, und
l) Aufsetzen des erhaltenen gestuften Leiterplattenverbunds auf den Kühlkörper derart, dass die Wärmeableitseite der zumindest einen Leiterplatte B flächig auf einer Auflagefläche des Kühlkörpers aufliegt, wobei die Auflagefläche des Kühlkörpers so dimensioniert und positioniert wird, dass sie sich zumindest teilweise lateral über die Wärmeableitseite der zumindest einen Leiterplatte B hinaus jeweils in Richtung der durch die Abschnitte der zumindest einen Leiterplatte A gebildeten Endbereiche erstreckt, und auf der Auflagefläche des Kühlkörpers Stützelemente zur mechanischen Stützung der durch die Abschnitte der zumindest einen Leiterplatte A gebildeten Endbereiche ausgebildet sind.

Mit Vorteil erfolgt in Schritt k) die Positionierung des zumindest einen elektronischen Bauteils mit spezifischen Anforderungen auf der Leiterplatte B mit Hilfe von auf der zumindest einen Leiterplatte A positionierten Referenzmarken.

Ein weiterer Gegenstand der Erfindung betrifft ein elektronisches Modul welches nach dem hierin beschriebenen erfindungsgemäßen Verfahren hergestellt ist.

Ein weiterer Gegenstand der Erfindung betrifft zudem eine Beleuchtungsvorrichtung für ein Kraftfahrzeug, insbesondere Kraftfahrzeugscheinwerfer, umfassend ein elektronisches Modul gemäß der Erfindung und wie hierin geoffenbart.

Ein weiterer Gegenstand der Erfindung ist die Verwendung eines elektronischen Moduls gemäß der Erfindung und wie hierin geoffenbart als oder in einer Beleuchtungsvorrichtung für ein Kraftfahrzeug.

Der Begriff "Kraftfahrzeug" (KFZ) bezieht sich auf ein- oder mehrspurige motorisierte landgebundene Fahrzeuge wie Motorräder, PKWs, LKWs und dergleichen.

Die Beleuchtungsvorrichtung für ein Kraftfahrzeug kann ein Kraftfahrzeugscheinwerfer, eine Heckleuchte oder eine Kraftfahrzeuginnenleuchte oder -außenleuchte sein. Der Kraftfahrzeugscheinwerfer ist nach an sich bekannten Scheinwerferbauprinzipien aufgebaut und umfasst typischerweise ein Gehäuse mit einer Lichtaustrittsöffnung, die mit einer Streuscheibe verdeckt ist, wobei erfindungsgemäß zumindest ein elektronisches Modul gemäß der Erfindung in dem Gehäuse angeordnet ist.

Bei bestimmten Varianten hat der Kraftfahrzeugscheinwerfer die Form eines Frontscheinwerfers. Der Aufbau eines Frontscheinwerfers ist dem einschlägigen Fachmann bekannt. Frontscheinwerfer umfassen häufig mehrere Lichtmodule, z.B. eine Tagfahrlichteinheit, eine Abblendlichteinheit, eine Fernlichteinheit, eine Blinklichteinheit etc. Dementsprechend können die jeweiligen Lichtmodule des Frontscheinwerfers die Lichtverteilung eines Abblendlichts, eines Fernlichts, eines Tagfahrlichts, eines Blinklichts usw. bilden. Die genannten Lichtmodule für Frontscheinwerfer können ein erfindungsgemäßes elektronisches Modul, beispielsweise mit einer LED-Anordnung als Hochleistungsbauteil und als Lichtquelle fungierend, umfassen.

Bei anderen Varianten hat der Kraftfahrzeugscheinwerfer die Form einer Heckleuchte. Der Aufbau einer Heckleuchte ist dem einschlägigen Fachmann bekannt. Heckleuchten umfassen häufig mehrere Lichtmodule, z.B. eine Rücklichteinheit, eine Bremslichteinheit, eine Blinklichteinheit etc. Dementsprechend können die jeweiligen Lichtmodule der Heckleuchte die Lichtverteilung eines Rücklichts, eines Bremslichts, eines Blinklichts usw. bilden. Die genannten Lichtmodule für Heckleuchten können ein erfindungsgemäßes elektronisches Modul, beispielsweise mit einer LED-Anordnung als Hochleistungsbauteil und als Lichtquelle fungierend, umfassen.

Das erfindungsgemäße elektronische Modul kann bei weiteren Varianten auch Bauteil einer alleinstehenden Kraftfahrzeugleuchte, z.B. ein Begrenzungslicht, sein, die außer der Begrenzungslichtfunktion keine weiteren Lichtfunktionen bzw. Lichtmodule enthält. Hierfür ist es von Vorteil, wenn die alleinstehende Kraftfahrzeugleuchte ein Gehäuse mit einer Lichtaustrittsöffnung, die mit einer Abdeckscheibe verdeckt ist, umfasst, wobei zumindest ein erfindungsgemäßes elektronisches Modul, beispielsweise mit einer LED-Anordnung als Hochleistungsbauteil und als Lichtquelle fungierend, in dem Gehäuse angeordnet ist. Die alleinstehende Kraftfahrzeugleuchte kann z.B. als alleinstehende Frontleuchte, als alleinstehende Heckleuchte, als alleinstehende Seitenmarkierungsleuchte oder als Kraftfahrzeuginnenraumleuchte realisiert sein.

Die Erfindung samt weiterer Vorzüge wird im Folgenden anhand von nicht einschränkenden Beispielen und beiliegenden Zeichnungen näher beschrieben, wobei die Zeichnungen zeigen:
**Fig. 1** **-** **Fig. 4** veranschaulichen ein Verfahren zur Herstellung eines elektronischen Moduls gemäß der Erfindung,
**Fig. 5** zeigt eine Variante der mechanischen Stützung der Endbereiche des Leiterplattenverbunds durch den Kühlkörper,
**Fig. 6** zeigt eine weitere Variante der mechanischen Stützung der Endbereiche des Leiterplattenverbunds durch den Kühlkörper,
**Fig. 7** zeigt eine weitere Variante der mechanischen Stützung der Endbereiche des Leiterplattenverbunds durch den Kühlkörper,
**Fig. 8** zeigt eine weitere Variante der mechanischen Stützung der Endbereiche des Leiterplattenverbunds durch den Kühlkörper und veranschaulicht die Möglichkeit einer z-Referenzierung,
**Fig. 9** zeigt die Variante aus Fig. 8 ergänzt um eine Primäroptik und einem Halterahmen für die Primäroptik,
**Fig. 10** und **Fig. 11** veranschaulichen ein weiteres, alternatives Verfahrens zur Herstellung eines elektronischen Moduls gemäß der Erfindung,
**Fig. 12** zeigt eine schematische Darstellung eines Aufbaus des Leiterplattenverbunds des elektronischen Moduls gemäß der Erfindung,
**Fig. 13** zeigt eine schematische Darstellung eines weiteren Aufbaus des Leiterplattenverbunds des elektronischen Moduls gemäß der Erfindung,
**Fig. 14** zeigt eine schematische Darstellung eines weiteren Aufbaus des Leiterplattenverbunds des elektronischen Moduls gemäß der Erfindung,
**Fig. 15** zeigt eine Weiterbildung des Aufbaus aus Fig. 14, und
**Fig. 16** zeigt eine schematische Darstellung eines weiteren Aufbaus des Leiterplattenverbunds des elektronischen Moduls gemäß der Erfindung unter Verwendung der Ball Grid Array (BGA)-Technik.

Es versteht sich, dass die hier beschriebenen Ausführungsformen und Varianten lediglich der Illustration dienen und nicht als für die Erfindung einschränkend aufzufassen sind;

In den Figuren werden für gleiche oder vergleichbare Elemente zum Zwecke der einfacheren Erläuterung und Darstellung gleiche Bezugszeichen verwendet. Die in den Ansprüchen verwendeten Bezugszeichen sollen weiters lediglich die Lesbarkeit der Ansprüche und das Verständnis der Erfindung erleichtern und haben keinesfalls einen den Schutzumfang der Erfindung beeinträchtigenden Charakter.

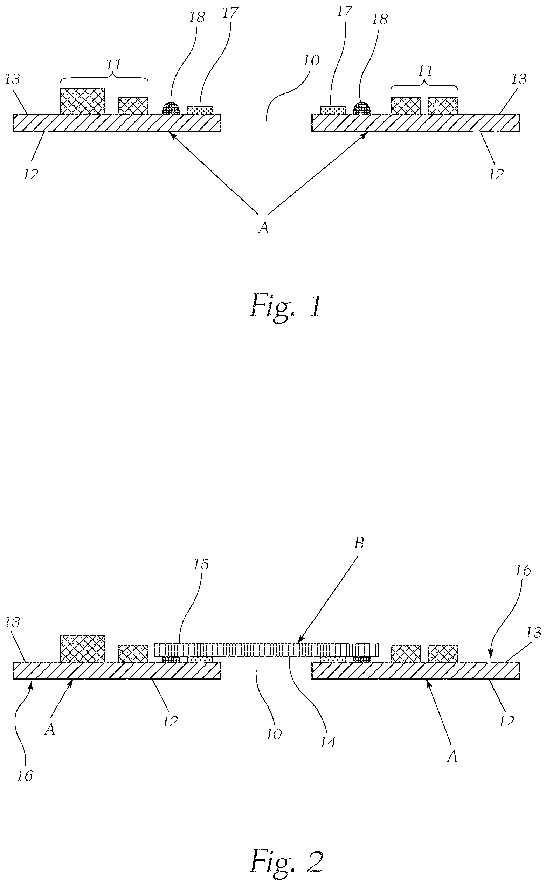

In den in Fig. 1 - 16 beschriebenen Varianten und Beispielen kann die Leiterplatte einer ersten Gattung (als "Leiterplatte A" bezeichnet bzw. in den Fig. 1-16 mit "A" gekennzeichnet) eine FR4-Leiterplatte sein. Die Leiterplatte einer zweiten Gattung (als "Leiterplatte B" bezeichnet bzw. in den Fig. 1-16 mit "B" gekennzeichnet) kann eine IMS-Leiterplatte sein. Das Hochleistungsbauteil kann ein optoelektronisches Bauteil wie beispielsweise eine Laserdiode, eine LED, eine LED-Anordnung, eine Photodiode oder ein DLP-Bauteil sein. Das Bestücken und fixieren der einzelnen Komponenten und Bauteilelemente zu einer Flachbaugruppe erfolgt mit hinlänglich bekannten und standardmäßig eingesetzten Techniken der SMT-Bauteilbestückung, einschließlich durch Aufbringen von Lotpaste und Reflow-Löten bzw. Aufbringen von Klebepunkten.

Die **Fig. 1** **-** **Fig. 4** veranschaulichen schematisch ein erstes Verfahren zur Herstellung eines elektronischen Moduls gemäß der Erfindung in einer standardmäßigen SMT-Bauteilbestückungslinie. Die in den Fig. 1 - Fig. 4 gezeigte Verfahrensvariante umfasst dabei die folgenden Schritte:
Erster Schritt: Bereitstellen einer Leiterplatte A, die eine erste Bestückungsseite 12 (top) und eine der ersten Bestückungsseite 12 abgewandte zweite Bestückungsseite 13 (bottom) aufweist. Ferner werden verschiedene elektronische Bauteilelemente 11 zur Bestückung der Leiterplatte A bereitgestellt. Fig. 1 zeigt einen vertikalen Schnitt durch eine Leiterplatte A, die mittig eine Ausnehmung 10 aufweist.

Zweiter Schritt: Bestücken (bottom-up) und Fixieren von verschiedenen elektronischen Bauteilelementen 11 auf der zweiten Bestückungsseite 13 der Leiterplatte A durch Reflow-Löten. Die zweite Bestückungsseite 13 der Leiterplatte A wird zudem mit Lotpaste 17 sowie mit Kleber 18 für das nachfolgende Fixieren der Leiterplatte B versehen. Die im zweiten Schritt erhaltene, einseitig mit den Bauteilelementen 11 bestückte Leiterplatte A ist in Fig. 1 dargestellt.

Dritter Schritt: Als nächstes wird eine Leiterplatte B bereitgestellt, welche eine Bestückungsseite 14 (top) und eine der Bestückungsseite 14 abgewandten Befestigungsseite 15 (bottom) aufweist.

Vierter Schritt: Bestücken (bottom-up) und Fixieren der Leiterplatte B auf der zweiten Bestückungsseite 13 der Leiterplatte A in überlappender Weise. Dabei wird, wie in Fig. 2 dargestellt ist, ein gestufter Leiterplattenverbund aus der Leiterplatte A und der Leiterplatte B erhalten, bei dem die Ausnehmung 10 der Leiterplatte A durch die Leiterplatte B überdeckt wird. Durch die bottom-up Bestückung der Leiterplatte B ist die Bestückungsseite 14 der Bestückungsseite 13 bzw. der Ausnehmung 10 zugewandt; die Befestigungsseite 15 ist entsprechend abgewandt. Der gestufte Leiterplattenverbund ist wie in Fig. 2 ersichtlich ist durch Endbereiche 16 begrenzt, welche durch Abschnitte der Leiterplatte A gebildet werden. Der im vierten Schritt erhaltene gestufte Leiterplattenverbund wird anschließend, wie bei einer doppelseitigen Bestückung üblich, gewendet.

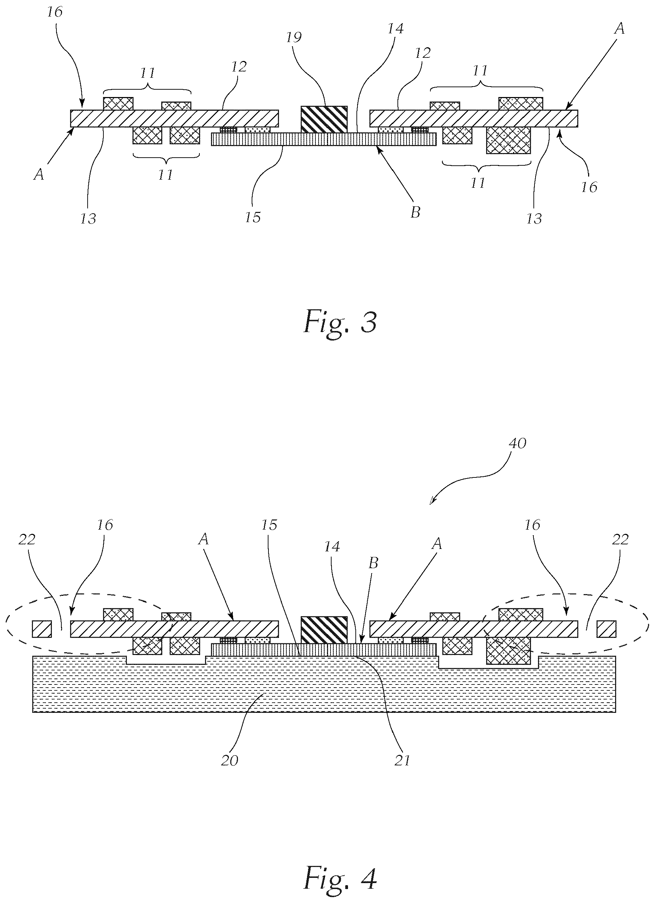

Fünfter Schritt: Bestücken (top-up) und Fixieren eines bereitgestellten elektronischen Bauteils mit spezifischen Anforderungen (im Folgenden als Hochleistungsbauteil 19 bezeichnet) auf der Bestückungsseite 14 der Leiterplatte B sowie von elektronischen Bauteilelementen 11 auf der ersten Bestückungsseite 12 der Leiterplatte B des gestuften Leiterplattenverbunds. Dabei wird ein beidseitig bestückter gestufter Leiterplattenverbund erhalten, der in Fig. 3 dargestellt ist. Das Hochleistungsbauteil 19 kann wie oben bereits erwähnt ein optoelektronisches Bauteil wie beispielsweise eine Laserdiode, eine LED, eine LED-Anordnung, eine Photodiode oder ein DLP-Bauteil sein. Im Fall einer LED strahlt diese durch die Ausnehmung 10 der Leiterplatte A.

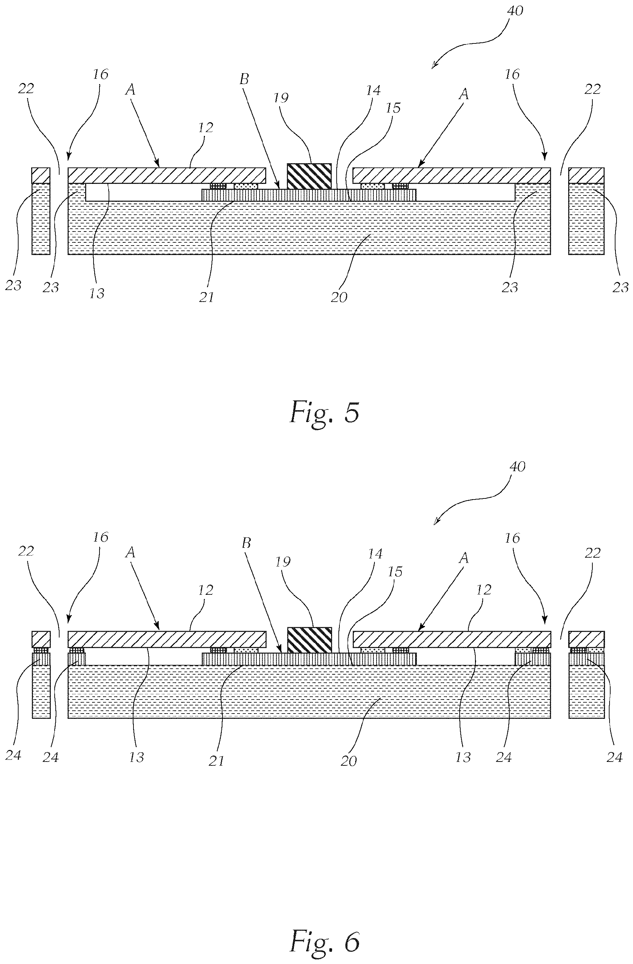

Sechster Schritt: Aufsetzen des in den vorhergehenden Schritten erhaltenen bestückten und gestuften Leiterplattenverbunds (siehe Aufbau in Fig. 3) auf einen Kühlkörper 20. Dies erfolgt dadurch, dass der Leiterplattenverbund mit der Befestigungsseite 15 der Leiterplatte B flächig auf einer Auflagefläche 21 des Kühlkörpers 20 befestigt wird, so dass die Befestigungsseite 15 auf der Auflagefläche 21 aufliegt (siehe Fig. 4). Die Auflagefläche 21 des Kühlkörpers 20 ist so dimensioniert und wird so positioniert, dass sie sich lateral über die Befestigungsseite 15 der Leiterplatte B hinaus jeweils in Richtung der durch die Abschnitte der Leiterplatte A gebildeten Endbereiche 16 erstreckt. In der in Fig. 4 gezeigten Darstellung erstreckt sich die Auflagefläche 21 lateral im Wesentlichen bis zu den äußersten Enden der Endbereiche 16. Die Auflagefläche 21 kann auch Einbuchtungen aufweisen, damit die auf der zweiten Bestückungsseite 13 der Leiterplatte A befestigten Bauteilelemente Platz finden. Die Leiterplatte A weist nach gängiger Weise Ausrichtungsbohrungen 9 zur lateralen Positionierung der einzelnen Bauteilelemente 11 und des Hochleistungsbauteils 19 auf. Wie nun in der Fig. 4 sehr gut erkennbar ist, schweben die Endbereiche 16 der Leiterplatte A in der Luft und sind daher einer Beschädigung durch Stöße oder Schwingungen ausgesetzt. Der schwingungs- und stoßgefährdete Bereich der Endbereiche 16 ist durch die gestrichelten Einrahmungen gekennzeichnet. Erfindungsgemäß sind bzw. werden nun auf der Auflagefläche 21 des Kühlkörpers 20 Stützelemente zur mechanischen Stützung der durch die Abschnitte der Leiterplatte A gebildeten und stoß- und schwingungsgefährdeten Endbereiche 16 ausgebildet (siehe beispielhafte Ausführungen in den Fig. 5 - 9), wodurch ein elektronisches Modul 40 mit einer hybriden Leiterplatte gemäß der Erfindung erhalten wird.

Verschiedene beispielhafte Varianten für derartige Stützelemente sind in den folgenden **Fig. 5 - 9** gezeigt. Diese zeigen eine vereinfachte Darstellung des Aufbaus des elektronischen Moduls 40 aus Fig. 4 mit verschiedenen Varianten der Stützelemente.

Eine erste Variante der mechanischen Stützung der Endbereiche 16 des Leiterplattenverbunds ist in **Fig. 5** gezeigt. Bei dieser Variante sind auf der Auflagefläche 21 des Kühlkörpers Stufen 23 als Stützelemente angeformt. Die Stufen 23 sind einstückig am Kühlkörper angeformt. Die Leiterplatte A liegt in ihren Endbereichen 16 mit ihrer zweiten Bestückungsseite 13 auf den Stufen 23 auf, wodurch die Endbereiche 16 mechanisch stabilisiert und gestützt werden. Die Endbereiche 16 können auf den Stufen 23 fixiert werden, beispielsweise mit einem Klebemittel.

**Fig. 6** zeigt eine weitere Variante der mechanischen Stützung der Endbereiche 16 des Leiterplattenverbunds. Bei dieser Variante sind auf der Auflagefläche 21 des Kühlkörpers beilagscheibenförmige Stufen 24 als Stützelemente befestigt. Die Leiterplatte A liegt in ihren Endbereichen 16 mit ihrer zweiten Bestückungsseite 13 auf den Beilagscheiben 24 auf, wodurch die Endbereiche 16 mechanisch stabilisiert und gestützt werden. Die Beilagscheiben 24 können aus demselben Material (z.B. IMS-Material) wie die Leiterplatte B (z.B. eine IMS-Leiterplatte) gefertigt sein und weisen dieselbe Dicke auf; vorzugsweise stammen die Beilagscheiben 24 und die Leiterplatte B aus derselben Charge, um Toleranzen in der Dicke sowie Langzeit-Abweichungen im Bestückungsprozess aufzuheben. Die Beilagscheiben 24 können insbesondere aus einem Material gefertigt sein, das in der Lage ist, thermische Energie von der Leiterplatte A an den Kühlkörper 20 abzuführen und/oder einen Potentialausgleich zwischen der Leiterplatte A und dem Kühlkörper zu ermöglichen. Für diese Zwecke können die Beilagscheiben 24 aus einem thermisch und/oder elektrisch leitfähigen Material, z.B. Kupfer oder Aluminium, gefertigt sein.

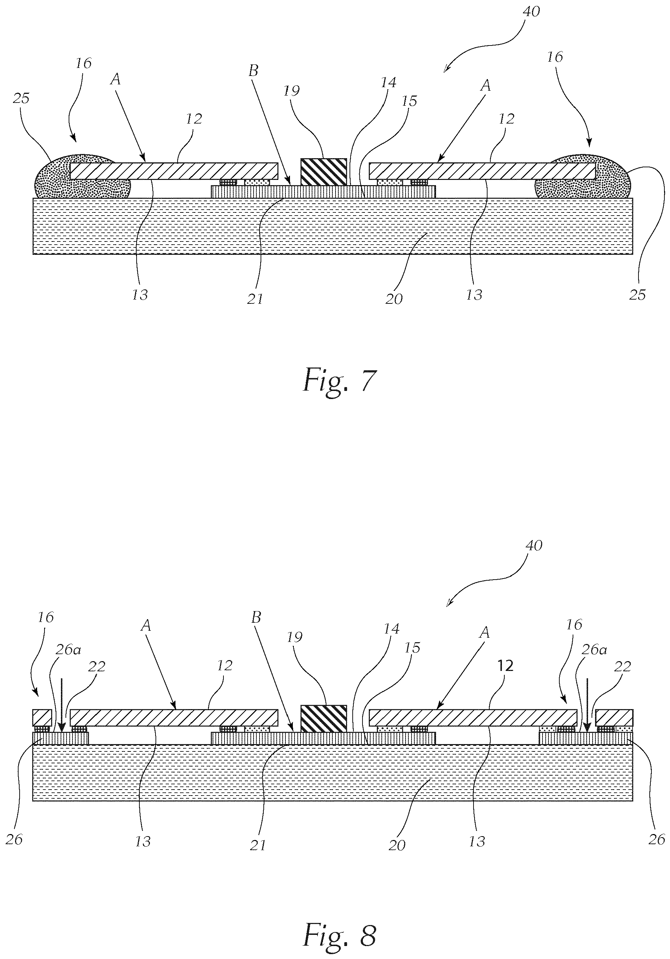

**Fig. 7** zeigt eine weitere Variante der mechanischen Stützung der Endbereiche 16 des Leiterplattenverbunds. Bei dieser Variante sind die Stützelemente mit einem "Gap Filler" in Form von strukturellem Klebstoff realisiert, der in Form von Klebepunkten 25 auf der Auflagefläche 21 des Kühlkörpers 20 aufgebracht ist. Diese Klebepunkte 25 stützen/ stabilisieren mechanisch die durch die Abschnitte der Leiterplatte A gebildeten Endbereiche 16 des Leiterplattenverbundes. Diese Variante bietet sich zum Beispiel dann an, wenn an den Endbereichen 16 der Leiterplatte A keine nennenswerten äußeren Kräfte angreifen und die Leiterplatte B (z.B. eine IMS-Leiterplatte) mit einem Klebemittel (z.B. einem thermisch leitfähigen Kleber) bereits mit ihrer Befestigungsfläche 15 auf der Auflagefläche 21 des Kühlkörpers 20 befestigt ist.

**Fig. 8** zeigt eine weitere Variante der mechanischen Stützung der Endbereiche 16 des Leiterplattenverbunds durch den Kühlkörper 20 und veranschaulicht zudem die Möglichkeit einer z-Referenzierung. Ähnlich wie bei der in Fig. 6 beschriebenen Variante sind bei dieser Variante auf der Auflagefläche 21 des Kühlkörpers 20 ebenfalls beilagscheibenförmige Stufen 26 als Stützelemente befestigt. Die Leiterplatte A liegt in ihren Endbereichen 16 mit ihrer zweiten Bestückungsseite 13 auf den Beilagscheiben 26 auf, wodurch die Endbereiche 16 mechanisch stabilisiert und gestützt werden. Die Beilagscheiben 26 sind bei diesem Beispiel aus demselben Material (z.B. IMS-Material) wie die Leiterplatte B (z.B. eine IMS-Leiterplatte) gefertigt und weisen im Wesentlichen dieselbe Dicke auf; vorzugsweise stammen die Beilagscheiben 26 und die Leiterplatte B aus derselben Charge, um Toleranzen in der Dicke sowie Langzeit-Abweichungen im Bestückungsprozess aufzuheben. Die Leiterplatte A weist wie oben beschrieben Ausrichtungsbohrungen 22 auf, und die Beilagscheiben 26 sind unterhalb der Ausrichtungsbohrungen 22 der Leiterplatte A auf der Auflagefläche 21 des Kühlkörpers 20 positioniert, so dass Oberflächenbereiche 26a der jeweiligen Beilagscheiben 26 durch die Ausrichtungsbohrungen 22 freigelegt sind. Der Bestücker kann zwar für die laterale Positionierung nach an sich bekannter Art und Weise die Ausrichtungsbohrungen 22 an der Leiterplatte A heranziehen, die z-Position ergibt sich jedoch aus der Oberfläche der Leiterplatte B, auf der das Hochleistungsbauteil 19 positioniert ist. Der freiliegende Oberflächenbereich 26a der jeweiligen Beilagscheibe 26 kann daher zur z-Referenzierung (in Fig. 8 durch die senkrechten Pfeile dargestellt) herangezogen werden. Wie in Fig. 8 gezeigt ist, sind die Ausrichtungsbohrungen 22 auf der kostengünstigeren Leiterplatte A angeordnet, weshalb die kostenintensivere Leiterplatte B sehr klein gehalten werden kann. Ein zusätzlicher und wesentlicher Vorteil dieser Variante liegt aber insbesondere darin, dass eine exakte z-Referenzierung und somit eine hochpräzise Positionierung des Hochleistungsbauteils 19 ermöglicht wird. Eine hochpräzise Positionierung ist besonders bei optoelektronischen Hochleistungsbauteilen, z.B. von LEDs, für lichttechnische Anwendungen, z.B. in Kraftfahrzeugscheinwerferanwendungen, von hoher Wichtigkeit. Die erreichbare Bestückgenauigkeit des hybriden gestuften Leiterplattenverbunds ist somit die gleiche wie bei "normalen" monolithischen Leiterplatten.

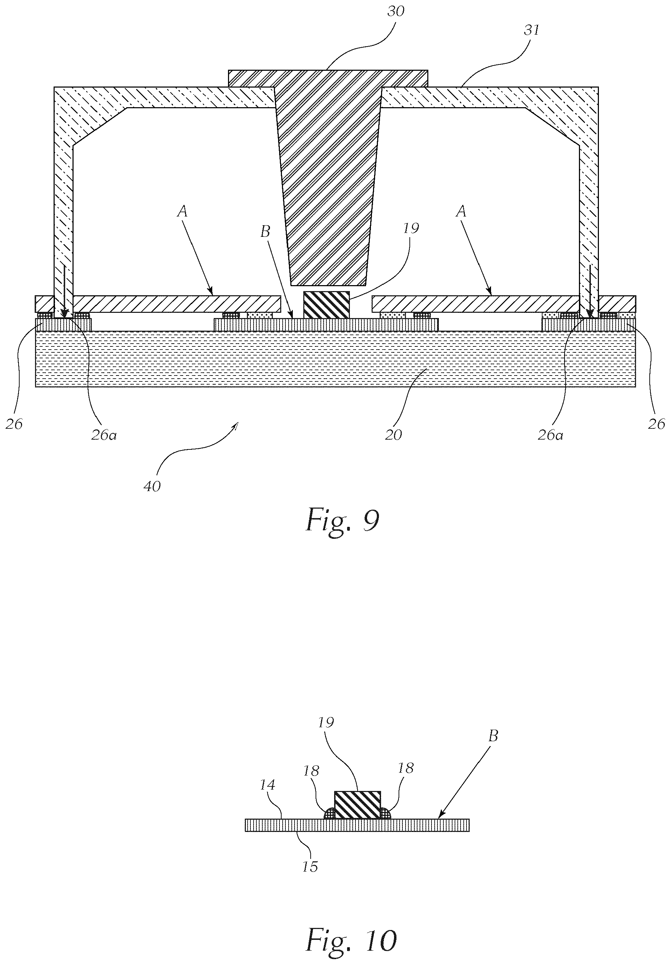

**Fig. 9** zeigt die Variante aus Fig. 8 ergänzt um eine Primäroptik 30 und einen Halterahmen 31 für die Primäroptik, unter der Annahme, dass es sich bei dem Hochleistungsbauteil 19 um eine LED-Anordnung handelt. Durch die Möglichkeit einer exakten z-Referenzierung (symbolisiert durch die senkrechten, auf die Oberflächenbereiche 26a gerichteten Pfeile) ist es möglich, die Primäroptik 30 hochpräzise zum Hochleistungsbauteil 19 (LED-Anordnung) zu positionieren.

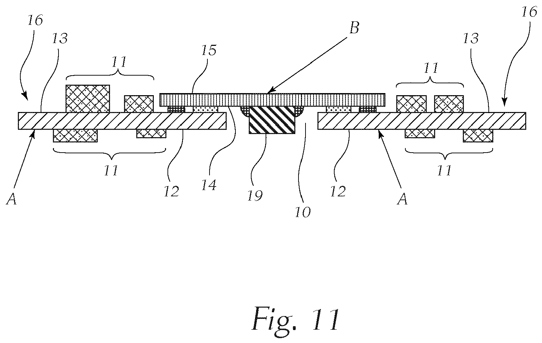

**Fig. 10** und **Fig. 11** veranschaulichen die anfänglichen Schritte eines weiteren, alternativen Verfahrens zur Herstellung eines elektronischen Moduls gemäß der Erfindung in einer standardmäßigen SMT-Bauteilbestückungslinie. Diese Verfahrensvariante umfasst dabei die folgenden Schritte:
Schritt 1: Bereitstellen einer Leiterplatte B mit einer Bestückungsseite 14 (top) und einer der Bestückungsseite 14 abgewandten Befestigungsseite 15 (bottom) sowie Bereitstellen von einem elektronischen Bauteil 19 (im Folgenden als Hochleistungsbauteil 19 bezeichnet) mit spezifischen Anforderungen. Das Hochleistungsbauteil 19 kann wie oben bereits erwähnt ein optoelektronisches Bauteil wie beispielsweise eine Laserdiode, eine LED, eine LED-Anordnung, eine Photodiode oder ein DLP-Bauteil sein.
Schritt 2: Bestücken (top-up) und Fixieren des elektronischen Hochleistungsbauteils 19 auf der Bestückungsseite 15 der Leiterplatte B durch Reflow-Löten. Das Hochleistungsbauteil 19 wird zusätzlich mittels Klebepunkten 18 auf der Leiterplatte B fixert. Diese Anordnung ist in Fig. 10 dargestellt. Anschließend wird die mit dem Hochleistungsbauteil 19 bestückte Leiterplatte B gewendet.
Schritt 3: Bereitstellen einer Leiterplatte A, die eine erste Bestückungsseite 12 (top) und eine der ersten Bestückungsseite 12 abgewandte zweite Bestückungsseite 13 (bottom) aufweist. Die Leiterplatte A weist, wie in Fig. 11 ersichtlich ist mittig eine Ausnehmung 10 auf. Ferner werden verschiedene elektronische Bauteilelemente 11 zur Bestückung der Leiterplatte A bereitgestellt.
Schritt 4: Bestücken (top-up) und Fixieren von elektronischen Bauteilelementen 11 auf der ersten Bestückungsseite 12 der Leiterplatte A und anschließend Wenden der Leiterplatte A.
Schritt 5: Bestücken (bottom-up) und Fixieren von elektronischen Bauteilelementen 11 auf der zweiten Bestückungsseite 13 der Leiterplatte A sowie Bestücken (bottom-up) und Fixieren der mit dem Hochleistungsbauteil 19 bestückten Leiterplatte B aus Schritt 2 auf der zweiten Bestückungsseite 13 der Leiterplatte A in überlappender Weise, zum Erhalt eines gestuften Leiterplattenverbunds, wobei der gestufte Leiterplattenverbund zumindest bereichsweise durch Endbereiche, welche durch Abschnitte der zumindest einen Leiterplatte A gebildet werden, begrenzt wird. Dabei wird, wie in Fig. 11 dargestellt ist, ein gestufter Leiterplattenverbund aus der Leiterplatte A und der Leiterplatte B erhalten, bei dem die Ausnehmung 10 der Leiterplatte A durch die Leiterplatte B überdeckt wird. Durch die bottom-up Bestückung der Leiterplatte B ist die Bestückungsseite 14 (Leiterplatte B) der Bestückungsseite 13 (Leiterplatte A) bzw. der Ausnehmung 10 zugewandt; die Befestigungsseite 15 der Leiterplatte B ist entsprechend abgewandt. Der gestufte Leiterplattenverbund ist wie in Fig. 11 ersichtlich ist durch Endbereiche 16 begrenzt, welche durch Abschnitte der Leiterplatte A gebildet werden.
Schritt 6: Der Schritt 6 dieser Verfahrensvariante entspricht dem Schritt 6 der oben beschriebenen anderen Verfahrensvariante und ist in Fig. 4 veranschaulicht. Aufsetzen des in den vorhergehenden Schritten erhaltenen bestückten und gestuften Leiterplattenverbunds (siehe Aufbau in Fig. 11) auf einen Kühlkörper 20. Dies erfolgt dadurch, dass der Leiterplattenverbund mit der Befestigungsseite 15 der Leiterplatte B flächig auf einer Auflagefläche 21 des Kühlkörpers 20 befestigt wird, so dass die Befestigungsseite 15 auf der Auflagefläche 21 aufliegt (siehe Fig. 4). Die Auflagefläche 21 des Kühlkörpers 20 ist so dimensioniert und wird so positioniert, dass sie sich lateral über die Befestigungsseite 15 der Leiterplatte B hinaus jeweils in Richtung der durch die Abschnitte der Leiterplatte A gebildeten Endbereiche 16 erstreckt. In der in Fig. 4 gezeigten Darstellung erstreckt sich die Auflagefläche 21 lateral im Wesentlichen bis zu den äußersten Enden der Endbereiche 16. Die Auflagefläche 21 kann auch Einbuchtungen aufweisen, damit die auf der zweiten Bestückungsseite 13 der Leiterplatte A befestigten Bauteilelemente Platz finden. Die Leiterplatte A weist nach gängiger Weise Ausrichtungsbohrungen 9 zur lateralen Positionierung der einzelnen Bauteilelemente 11 und des Hochleistungsbauteils 19 auf. Wie nun in der Fig. 4 sehr gut erkennbar ist, schweben die Endbereiche 16 der Leiterplatte A in der Luft und sind daher einer Beschädigung durch Stöße oder Schwingungen ausgesetzt. Der schwingungs- und stoßgefährdete Bereich der Endbereiche 16 ist durch die gestrichelten Einrahmungen gekennzeichnet. Erfindungsgemäß sind bzw. werden nun auf der Auflagefläche 21 des Kühlkörpers 20 Stützelemente zur mechanischen Stützung der durch die Abschnitte der Leiterplatte A gebildeten und stoß- und schwingungsgefährdeten Endbereiche 16 ausgebildet, wodurch ein elektronisches Modul 40 mit einer hybriden Leiterplatte gemäß der Erfindung erhalten wird.

Die verschiedenen beispielhaften Varianten für Stützelemente, die in den Fig. 5 - 9 gezeigt und oben in Verbindung mit der anderen Verfahrensvariante beschrieben sind, sind auf diese alternative Verfahrensvariante in identischer Weise anzuwenden. Auf die obige Beschreibung der in den Fig. 5 - 9 dargestellten Ausführungsbeispiele für Stützelemente wird verwiesen.

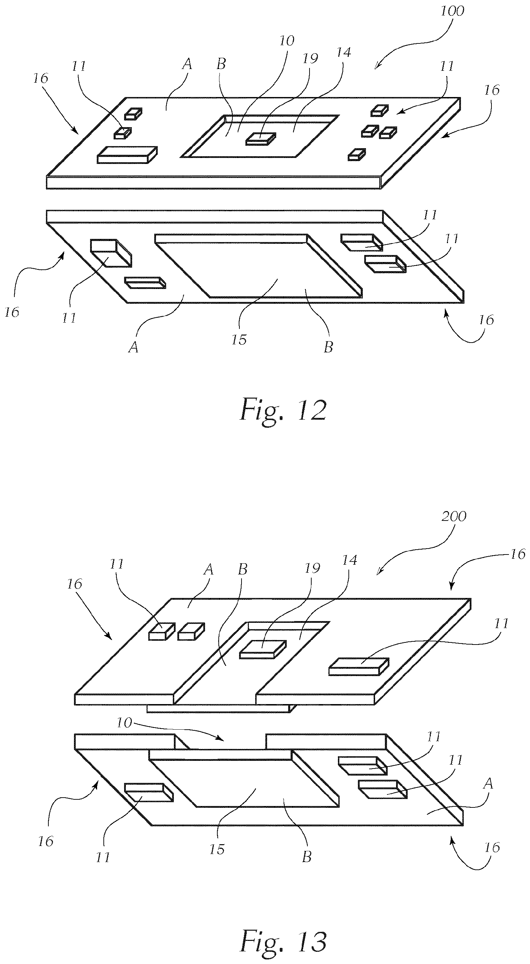

Die **Fig. 12 - 16** zeigen verschiedene Beispiele für den Aufbau eines hybriden gestuften Leiterplattenverbunds als Bestandteil eines elektronischen Moduls gemäß der Erfindung. Ein hybrider gestufter Leiterplattenverbund wird, wie hierin eingehend beschrieben ist, dadurch erhalten, dass zumindest eine, gegebenenfalls beidseitig bestückte, Leiterplatte einer ersten Gattung (als "Leiterplatte A" bezeichnet; z.B. eine FR4-Leiterplatte) in überlappender Weise mit zumindest einer Leiterplatte einer zweiten Gattung (als "Leiterplatte B" bezeichnet; z.B. eine IMS-Leiterplatte) bestückt wird. Die Leiterplatte B ist auf einer Bestückungsseite 14 mit einem elektronischen Bauteil mit spezifischen Anforderungen (als Hochleistungsbauteil 19 bezeichnet; z.B. ein optoelektronische Bauteil wie eine LED-Anordnung) bestückt. Der gestufte Leiterplattenverbund, der jeweils in den Fig. 12 - 16 in verschiedenen Varianten dargestellt ist, wird anschließend auf einem Kühlkörper aufgesetzt, wobei eine Befestigungsseite 15 der Leiterplatte B flächig auf einer Auflagefläche des Kühlkörpers aufliegt. Erfindungsgemäß werden die durch Abschnitte der zumindest einen Leiterplatte A gebildeten Endbereiche 16 des Leiterplattenverbunds durch Stützelemente mechanisch gestützt, die auf der Auflagefläche des Kühlkörpers ausgebildet sind (vgl. Fig. 4); die in den Fig. 12 - 16 gezeigten beispielhaften Leiterplattenverbunde sind mit den in Fig. 5 - 9 gezeigten Beispielen für Stützelemente kombinierbar. Die Leiterplatte A ist in den in Fig. 12-16 gezeigten Beispielen beidseitig mit elektronischen Bauteilelementen 11 bestückt.

**Fig. 12** zeigt eine schematische Darstellung eines vorteilhaften Aufbaus eines Leiterplattenverbunds 100 eines elektronischen Moduls gemäß der Erfindung in zwei Perspektiven (von unten und von oben). Der in Fig. 12 dargestellte Aufbau des Leiterplattenverbunds 100 zeigt eine Aufsicht des oben in Bezug auf die beiden Herstellungsverfahren (vergleiche Fig. 1 - 11) beschriebenen Leiterplattenverbunds als Bestandteil eines elektronischen Moduls 40. Diese Variante umfasst eine beidseitig mit Bauteilelementen 11 bestückte Leiterplatte A mit einer Ausnehmung 10 und eine Leiterplatte B. Die Ausnehmung 10 ist im Wesentlichen fensterförmig und im gezeigten Beispiel besitzt sie eine rechteckige Form. Einem Fachmann wird klar sein, dass die Form der fensterförmigen Ausnehmung 10 frei wählbar und andere Formen als eine rechteckige Form annehmen kann, beispielsweise quadratisch, rechteckig, viereckig, rund, abgerundet etc. sein. In der praktischen Umsetzung ist die Ausnehmung 10 jedoch typischerweise rechteckig oder quadratisch gewählt. Die Leiterplatte B ist in überlappender Weise derart mit der Leiterplatte A verbunden, dass die Leiterplatte B die Ausnehmung der Leiterplatte A vollständig überdeckt. Die Leiterplatte B ist ferner mit einem Hochleistungsbauteil 19 bestückt, welches sich durch die Ausnehmung 10 in der Leiterplatte A hindurch erstreckt. Bei der in Fig. 12 gezeigten Variante wird ein mechanisch besonders stabiles elektronisches Modul erhalten. Zudem lassen sich die den Leiterplattenverbund 100 ausbildenden Leiterplatten A und B in vielfältiger Weise miteinander kontaktieren und ermöglichen komplexe Designs und Kontaktierungen. Beispielsweise wird die Leiterplatte A (z.B. eine FR4-Leiterplatte) mit der Leiterplatte B (z.B. eine IMS-Leiterplatte) so bestückt, dass die Leiterplatte B die fensterförmige Ausnehmung 10 überdeckt und entlang der Begrenzungslinie der Ausnehmung 10 mit der Leiterplatte A überlappt. Das auf der Leiterplatte B angeordnete Hochleistungsbauteil 19 (z.B. eine LED-Anordnung) ist dabei so angeordnet und positioniert, dass es sich durch die Ausnehmung in der Leiterplatte A erstreckt (z.B. im Fall einer auf der Leiterplatte B fixierten LED-Anordnung strahlt die LED durch die Ausnehmung in der Leiterplatte A durch).

**Fig. 13** zeigt eine schematische Darstellung eines weiteren Aufbaus eines Leiterplattenverbunds 200 eines elektronischen Moduls gemäß der Erfindung in zwei Perspektiven (von unten und von oben). Im Gegensatz zu dem in Fig. 12 gezeigten Leiterplattenverbund 100 ist beim Leiterplattenverbund 200 die Ausnehmung U-förmig. Der Leiterplattenverbund 200 stellt eine spezifische Ausgestaltungen dar, die bei speziellen Designs zur Anwendung kommen kann.

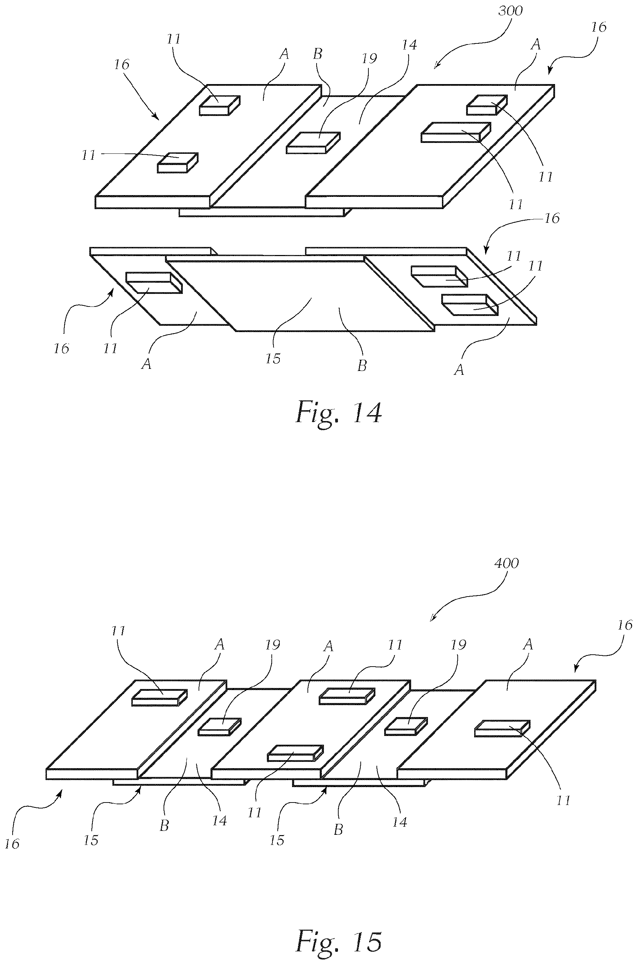

**Fig. 14** zeigt eine schematische Darstellung eines weiteren Aufbaus eines Leiterplattenverbunds 300 eines elektronischen Moduls gemäß der Erfindung in zwei Perspektiven (von oben und von unten). Bei dieser Variante sind zwei voneinander beabstandete Leiterplatten A in überlappender Weise mit einer Leiterplatte B verbunden, so dass ein in Längsrichtung gestufter Leiterplattenverbund 300 mit seriell alternierend verbundenen Leiterplatten A und B erhalten wird. Die zwei Leiterplatten A sind im Wesentlichen in einer Ebene angeordnet und die Leiterplatte B ist in einer durch die Überlappung gebildeten weiteren Ebene angeordnet. Die Endbereiche 16 des Leiterplattenverbunds 300 werden durch einen Abschnitt einer jeweils endständigen Leiterplatte A gebildet.

**Fig. 15** zeigt eine schematische Darstellung eines Leiterplattenverbunds 400 in perspektivischer Ansicht von oben. Der Leiterplattenverbund ist eine Weiterbildung des Leiterplattenverbunds 300 aus Fig. 14, bei dem insgesamt drei Leiterplatten A in seriell alternierender Weise überlappend mit zwei Leiterplatten B verbunden werden. Es wird ein in Längsrichtung gestufter Leiterplattenverbund 400 mit seriell alternierend verbundenen Leiterplatten A und B erhalten wird. Die drei Leiterplatten A sind im Wesentlichen in einer Ebene angeordnet und die zwei Leiterplatten B sind im Wesentlichen in einer durch die Überlappung gebildeten weiteren Ebene angeordnet. Die Endbereiche 16 des Leiterplattenverbunds 400 werden durch einen Abschnitt einer jeweils endständigen Leiterplatte A gebildet.

Der Leiterplattenverbund 300 und der Leiterplattenverbund 400 stellen spezifische Ausgestaltungen dar, die bei speziellen Designs zur Anwendung kommen können.

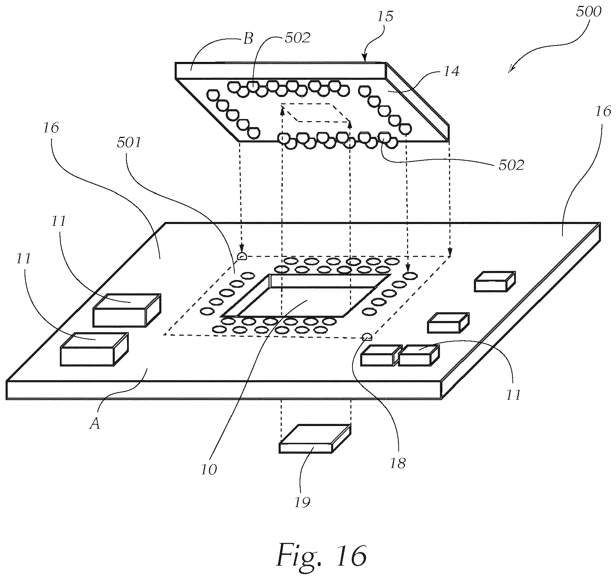

**Fig. 16** zeigt eine schematische Darstellung eines Leiterplattenverbunds 500 eines elektronischen Moduls gemäß der Erfindung in perspektivischer Ansicht und explodierter Form von oben. Der in Fig. 16 dargestellte Leiterplattenverbund 500 stellt eine Abwandlung des in Fig. 12 gezeigten Leiterplattenverbunds 100 dar, mit dem Unterschied, dass beim Leiterplattenverbund 500 die mit einer fensterförmigen Ausnehmung 10 versehene Leiterplatte A und die mit dem Hochleistungsbauteil 19 bestückte Leiterplatte B in deren Überlappungsbereich 501 mittels Ball Grid Array (BGA)-Technik miteinander kontaktiert werden. Die BGA-Kontaktierungstechnik ist einem Fachmann auf dem Gebiet hinlänglich bekannt und ermöglicht eine höhere Anzahl von Anschlüssen und einen verbesserten Wärmetransport. Die in der BGA-Technik verwendeten Lotkugeln ("balls"; in Fig. 16 mit dem Bezugszeichen 502 gekennzeichnet) können dabei nach an sich bekannter Weise an vorgesehen Kontaktpads auf einer der zu verbindenen Leiterplatten (hier auf der Leiterplatte B) aufgebracht werden. Alternativ können die Lotkugeln auch durch Aufrakeln von Lotpaste und anschließendes Schmelzen in einem Reflow-Prozess, wonach sich die Lotpaste beim Abkühlen zu Lotkugeln zusammenzieht, auf den Kontaktpads aufgebracht werden. Ein weiteres bekanntes Verfahren zum Aufbringen von Lotkugeln ist das einzelne Aufbringen von vorgefertigten BGA-Lotkugeln in einem Bestückungsautomaten mit Hilfe von Minidüsen auf die Kontaktpads der Leiterplatte.

Die Erfindung kann im Rahmen des Schutzbereichs der unabhängigen Ansprüche in beliebiger dem Fachmann bekannter Weise abgeändert werden und ist nicht auf die gezeigten Ausführungsformen beschränkt.

### BEZUGSZEICHENLISTE

- A: Leiterplatte einer ersten Gattung
- B: Leiterplatte einer zweiten Gattung
- 10: Ausnehmung
- 11: Bauteilelement
- 12: erste Bestückungsseite (top) einer Leiterplatte A
- 13: zweite Bestückungsseite (bottom) einer Leiterplatte A
- 14: Bestückungsseite (top) einer Leiterplatte B
- 15: Befestigungsseite (bottom) einer Leiterplatte B
- 16: Endbereich einer Leiterplatte A
- 17: Lotpaste
- 18: Kleber
- 19: Hochleistungsbauteil
- 20: Kühlkörper
- 21: Auflagefläche des Kühlkörpers
- 22: Ausrichtungsbohrung
- 23: Stufe am Kühlkörper
- 24: beilagscheibenförmige Stufe
- 25: Klebepunkt
- 26: beilagscheibenförmige Stufe
- 26a: Oberflächenbereich der Beilagscheibe 26
- 30: Primäroptik
- 31: Halterahmen
- 40: elektronisches Modul
- 100: Leiterplattenverbund
- 200: Leiterplattenverbund
- 300: Leiterplattenverbund
- 400: Leiterplattenverbund
- 500: Leiterplattenverbund
- 501: Überlappungsbereich
- 502: BGA-Lotkugel

## Patentansprüche

1. Elektronisches Modul (40) umfassend zumindest eine, gegebenenfalls beidseitig bestückte, Leiterplatte einer ersten Gattung (als "Leiterplatte A" bezeichnet), die in überlappender Weise mit zumindest einer Leiterplatte einer zweiten Gattung (als "Leiterplatte B" bezeichnet) bestückt ist, wobei die Leiterplatte B mit zumindest einem elektronischen Bauteil mit spezifischen Anforderungen (19) bestückt ist, und die miteinander verbundenen Leiterplatten A und B einen gestuften Leiterplattenverbund (100, 200, 300, 400, 500) bilden, wobei der gestufte Leiterplattenverbund (100, 200, 300, 400, 500) zumindest bereichsweise durch Endbereiche (16), welche durch Abschnitte der zumindest einen Leiterplatte A gebildet werden, begrenzt ist, und der gestufte Leiterplattenverbund (100, 200, 300, 400, 500) auf einem Kühlkörper (20) aufgesetzt ist, wobei eine Befestigungsseite (15) der zumindest einen Leiterplatte B flächig auf einer Auflagefläche (21) des Kühlkörpers (20) aufliegt,
**dadurch gekennzeichnet, dass**
die Auflagefläche (21) des Kühlkörpers (20) so dimensioniert und positioniert ist, dass sie sich zumindest teilweise lateral über die Befestigungsseite (15) der zumindest einen Leiterplatte B hinaus jeweils in Richtung der durch die Abschnitte der zumindest einen Leiterplatte A gebildeten Endbereiche (16) erstreckt, und dass auf der Auflagefläche (21) des Kühlkörpers Stützelemente (23, 24, 25, 26) zur mechanischen Stützung der durch die Abschnitte der zumindest einen Leiterplatte A gebildeten Endbereiche (16) ausgebildet sind.

2. Elektronisches Modul nach Anspruch 1, **dadurch gekennzeichnet, dass** die zumindest eine Leiterplatte A zumindest eine Ausnehmung (10) aufweist und dass die zumindest eine Leiterplatte B in überlappender Weise derart mit der zumindest einen Leiterplatte A verbunden ist, dass jeweils eine Leiterplatte B jeweils eine Ausnehmung (10) der Leiterplatte A zumindest bereichsweise, vorzugsweise vollständig, überdeckt.

3. Elektronisches Modul nach Anspruch 1 oder 2, **dadurch gekennzeichnet, dass** die zumindest eine Ausnehmung (10) im Wesentlichen fensterförmig ist.

4. Elektronisches Modul nach einem der Ansprüche 1 bis 3, **dadurch gekennzeichnet, dass** die Stützelemente (24, 25, 26) auf der Auflagefläche (21) des Kühlkörpers (20) aufgebracht sind oder die Stützelemente (23) auf der Auflagefläche (21) des Kühlkörpers (20), gegebenenfalls einstückig, angeformt sind, und die Stützelemente (21) dazu eingerichtet sind, die durch die Abschnitte der zumindest einen Leiterplatte A gebildeten Endbereiche (16) des Leiterplattenverbundes (100, 200, 300, 400, 500) zu stützen.

5. Elektronisches Modul nach Anspruch 4, **dadurch gekennzeichnet, dass** im Bereich der durch die Abschnitte der zumindest einen Leiterplatte A gebildeten Endbereiche (16) des Leiterplattenverbunds (100, 200, 300, 400, 500) Beilagscheiben (24, 26) aus Leiterplatten B-Material als Stützelemente auf der Auflagefläche (21) des Kühlkörpers (20) aufgebracht sind, und die Endbereiche (16) des Leiterplattenverbunds (100, 200, 300, 400, 500) auf den Beilagscheiben (24, 26) aufsitzen und durch diese gestützt werden, wobei das Leiterplatten B-Material für die Beilagscheiben (24, 26) aus derselben Charge gewählt ist, aus der das Leiterplatten B-Material für die zumindest eine Leiterplatte B stammt.

6. Elektronisches Modul nach Anspruch 5, **dadurch gekennzeichnet, dass** die zumindest eine Leiterplatte A Ausrichtungsbohrungen (22) aufweist, und die Beilagscheiben (26) unterhalb der Ausrichtungsbohrungen der zumindest einen Leiterplatte A auf der Auflagefläche des Kühlkörpers positioniert sind, so dass Oberflächenbereiche (26a) der jeweiligen Beilagscheiben (26) durch die Ausrichtungsbohrungen (22) freigelegt sind.

7. Elektronisches Modul nach einem der Ansprüche 1 bis 6, **dadurch gekennzeichnet, dass** die Stützelemente (23, 24, 25, 26) dazu eingerichtet sind, thermische Energie von der zumindest einen Leiterplatte A an den Kühlkörper abzuführen und/oder einen Potentialausgleich zwischen der zumindest einen Leiterplatte A und dem Kühlkörper zu ermöglichen.

8. Elektronisches Modul nach einem der Ansprüche 1 bis 7, **dadurch gekennzeichnet, dass** die zumindest eine Leiterplatte A und die zumindest eine Leiterplatte B in deren Überlappungsbereich (501) mittels Ball Grid Array (BGA)-Technik miteinander kontaktiert sind.

9. Verfahren zur Herstellung eines elektronischen Moduls in einer Bauteilbestückungslinie, das elektronische Modul umfassend einen gestuften Leiterplattenverbund mit zumindest einem elektronischen Bauteil mit spezifischen Anforderungen und einen Kühlkörper, wobei das Verfahren umfasst:
Bestücken zumindest einer, gegebenenfalls beidseitig bestückten oder zu bestückenden, Leiterplatte einer ersten Gattung (als "Leiterplatte A" bezeichnet) in überlappender Weise mit zumindest einer Leiterplatte einer zweiten Gattung (als "Leiterplatte B" bezeichnet), wobei die Leiterplatte B mit zumindest einem elektronischen Bauteil mit spezifischen Anforderungen bestückt ist oder bestückt wird, zum Erhalt eines gestuften Leiterplattenverbunds, wobei der gestufte Leiterplattenverbund zumindest bereichsweise durch Endbereiche, welche durch Abschnitte der zumindest einen Leiterplatte A gebildet werden, begrenzt wird, und
Aufsetzen des erhaltenen gestuften Leiterplattenverbunds auf den Kühlkörper derart, dass eine Befestigungsseite der zumindest einen Leiterplatte B flächig auf einer Auflagefläche des Kühlkörpers aufliegt, wobei die Auflagefläche des Kühlkörpers so dimensioniert und positioniert wird, dass sie sich zumindest teilweise lateral über die Befestigungsseite der zumindest einen Leiterplatte B hinaus jeweils in Richtung der durch die Abschnitte der zumindest einen Leiterplatte A gebildeten Endbereiche erstreckt, und wobei auf der Auflagefläche des Kühlkörpers Stützelemente zur mechanischen Stützung der durch die Abschnitte der zumindest einen Leiterplatte A gebildeten Endbereiche ausgebildet sind.

10. Verfahren zum Herstellen eines elektronischen Moduls nach Anspruch 9, wobei das Verfahren die Schritte umfasst:
a) Bereitstellen zumindest einer Leiterplatte B mit einer Bestückungsseite (top) und einer der Bestückungsseite abgewandten Befestigungsseite (bottom) sowie Bereitstellen von zumindest einem elektronischen Bauteil mit spezifischen Anforderungen,
b) Bestücken (top-up) und Fixieren des zumindest einen elektronischen Bauteils mit spezifischen Anforderungen auf der Bestückungsseite der zumindest einen Leiterplatte B und anschließend Wenden der Leiterplatte B,
c) Bereitstellen zumindest einer Leiterplatte A mit einer ersten Bestückungsseite (top) und einer der ersten Bestückungsseite abgewandten zweiten Bestückungsseite (bottom) sowie Bereitstellen von elektronischen Bauteilelementen,
d) Bestücken (top-up) und Fixieren von elektronischen Bauteilelementen auf der ersten Bestückungsseite der zumindest einen Leiterplatte A und anschließend Wenden der Leiterplatte A,
e) Bestücken (bottom-up) und Fixieren von elektronischen Bauteilelementen auf der zweiten Bestückungsseite der zumindest einen Leiterplatte A sowie Bestücken (bottom-up) und Fixieren der zumindest einen bestückten Leiterplatte B aus Schritt b) auf der zweiten Bestückungsseite der zumindest einen Leiterplatte A in überlappender Weise, zum Erhalt eines gestuften Leiterplattenverbunds, wobei der gestufte Leiterplattenverbund zumindest bereichsweise durch Endbereiche, welche durch Abschnitte der zumindest einen Leiterplatte A gebildet werden, begrenzt wird, und
f) Aufsetzen des erhaltenen gestuften Leiterplattenverbunds auf den Kühlkörper derart, dass die Befestigungsseite der zumindest einen Leiterplatte B flächig auf einer Auflagefläche des Kühlkörpers aufliegt, wobei die Auflagefläche des Kühlkörpers so dimensioniert und positioniert wird, dass sie sich zumindest teilweise lateral über die Befestigungsseite der zumindest einen Leiterplatte B hinaus jeweils in Richtung der durch die Abschnitte der zumindest einen Leiterplatte A gebildeten Endbereiche erstreckt, und auf der Auflagefläche des Kühlkörpers Stützelemente zur mechanischen Stützung der durch die Abschnitte der zumindest einen Leiterplatte A gebildeten Endbereiche ausgebildet sind.

11. Verfahren zum Herstellen eines elektronischen Moduls nach Anspruch 9, wobei das Verfahren die Schritte umfasst:
g) Bereitstellen zumindest einer Leiterplatte A mit einer ersten Bestückungsseite (top) und einer der ersten Bestückungsseite abgewandten zweiten Bestückungsseite (bottom) sowie Bereitstellen von elektronischen Bauteilelementen,
h) Bestücken (bottom-up) und Fixieren von elektronischen Bauteilelementen auf der zweiten Bestückungsseite der zumindest einen Leiterplatte A,
i) Bereitstellen zumindest einer Leiterplatte B mit einer Bestückungsseite (top) und einer der Bestückungsseite abgewandten Befestigungsseite (bottom),
j) Bestücken (bottom-up) und Fixieren der zumindest einen Leiterplatte B auf der zweiten Bestückungsseite der zumindest einen Leiterplatte A in überlappender Weise, zum Erhalt eines gestuften Leiterplattenverbunds, wobei der gestufte Leiterplattenverbund zumindest bereichsweise durch Endbereiche, welche durch Abschnitte der zumindest einen Leiterplatte A gebildet werden, begrenzt wird, und anschließend Wenden des gestuften Leiterplattenverbunds,
k) Bestücken (top-up) und Fixieren zumindest eines bereitgestellten elektronischen Bauteils mit spezifischen Anforderungen auf der Bestückungsseite der zumindest einen Leiterplatte B sowie von elektronischen Bauteilelementen auf der ersten Bestückungsseite der zumindest einen Leiterplatte B des gestuften Leiterplattenverbunds aus Schritt j), zum Erhalt eines beidseitig bestückten gestuften Leiterplattenverbunds, und
l) Aufsetzen des erhaltenen gestuften Leiterplattenverbunds auf den Kühlkörper derart, dass die Befestigungsseite der zumindest einen Leiterplatte B flächig auf einer Auflagefläche des Kühlkörpers aufliegt, wobei die Auflagefläche des Kühlkörpers so dimensioniert und positioniert wird, dass sie sich zumindest teilweise lateral über die Befestigungsseite der zumindest einen Leiterplatte B hinaus jeweils in Richtung der durch die Abschnitte der zumindest einen Leiterplatte A gebildeten Endbereiche erstreckt, und auf der Auflagefläche des Kühlkörpers Stützelemente zur mechanischen Stützung der durch die Abschnitte der zumindest einen Leiterplatte A gebildeten Endbereiche ausgebildet sind.

12. Verfahren nach Anspruch 11, **dadurch gekennzeichnet, dass** in Schritt k) die Positionierung des zumindest einen elektronischen Bauteils mit spezifischen Anforderungen auf der Leiterplatte B mit Hilfe von auf der zumindest einen Leiterplatte A positionierten Referenzmarken erfolgt.

13. Elektronisches Modul (40) hergestellt nach einem der Ansprüche 9 bis 12.

14. Beleuchtungsvorrichtung für ein Kraftfahrzeug, insbesondere Kraftfahrzeugscheinwerfer, umfassend ein elektronisches Modul (40) nach einem der Ansprüche 1 bis 9 und 13.

15. Verwendung eines elektronischen Moduls nach einem der Ansprüche 1 bis 9 und 13 als oder in einer Beleuchtungsvorrichtung für ein Kraftfahrzeug.

## Claims

1. An electronic module (40) comprising at least one circuit board, possibly fitted with components on both sides, of a first type (referred to as "circuit board A"), which is fitted with at least one circuit board of a second type (referred to as "circuit board B") in an overlapping manner, wherein the circuit board B is fitted with at least one electronic component with specific requirements (19) and the interconnected circuit boards A and B form a tiered circuit board combination (100, 200, 300, 400, 500), wherein the tiered circuit board combination (100, 200, 300, 400, 500) is delimited at least in some areas by end portions (16) which are formed by sections of the at least one circuit board A, and the tiered circuit board combination (100, 200, 300, 400, 500) is mounted on a heat sink (20), wherein a mounting side (15) of the at least one circuit board B rests flat on a support surface (21) of the heat sink (20), **characterized in that** the support surface (21) of the heat sink (20) is dimensioned and positioned in such a way that it at least partially extends laterally beyond the mounting side (15) of the at least one circuit board B in the respective directions of the end portions (16) formed by the sections of at least one circuit board A, and that support elements (23, 24, 25, 26) are designed on the support surface (21) of the heat sink for mechanically supporting the end portions (16) formed by the sections of the at least one circuit board A.

2. The electronic module according to Claim 1, **characterized in that** the at least one circuit board A has at least one recess (10) and that the at least one circuit board B is connected to the at least one circuit board A in an overlapping manner such that each respective circuit board B covers a recess (10) of the circuit board A at least in portions, preferably completely.

3. The electronic module according to Claim 1 or 2, **characterized in that** the at least one recess (10) is essentially window-shaped.

4. The electronic module according to any one of Claims 1 to 3, **characterized in that** the support elements (24, 25, 26) are attached to the support surface (21) of the heat sink (20) or that the support elements (23) are moulded on the support surface (21) of the heat sink (20), possibly in one piece with the support surface, and that the support elements (21) are designed for supporting the end portions (16) of the circuit board combination (100, 200, 300, 400, 500) formed by the sections of the at least one circuit board A.

5. The electronic module according to Claim 4, **characterized in that** washers (24, 26) made of the same material as the circuit board B are attached to the support surface (21) of the heat sink (20) as support elements in the area of the end portions (16) of the circuit board combination (100, 200, 300, 400, 500) formed by the sections of the at least one circuit board A, and that the end portions (16) of the circuit board combination (100, 200, 300, 400, 500) rest on the washers (24, 26) and are supported by the same, wherein the material for the circuit board B used for the washers (24, 26) is selected from the same batch from which the circuit board material for the at least one circuit board B was selected.

6. The electronic module according to Claim 5, **characterized in that** the at least one circuit board A has alignment holes (22), and that the washers (26) are positioned below the alignment holes of the at least one circuit board A on the support surface of the heat sink such that surface areas (26a) of the respective washers (26) are exposed by the alignment holes (22).

7. The electronic module according to any one of Claims 1 to 6, **characterized in that** the support elements (23, 24, 25, 26) are set up to dissipate thermal energy from the at least one circuit board A to the heat sink and/or to facilitate a potential equalization between the at least one circuit board A and the heat sink.

8. The electronic module according to any one of Claims 1 to 7, **characterized in that** the at least one circuit board A and the at least one circuit board B are in contact with each other by means of Ball Grid Array (BGA) technology in their overlap area (501).

9. A method for producing an electronic module in a component placement line, the electronic module comprising a tiered circuit board combination with at least one electronic component with specific requirements and a heat sink, wherein the method comprises:
placement of components on at least one circuit board, possibly fitted or to be fitted with components on both sides, of a first type (referred to as "circuit board A") in an overlapping manner with at least one circuit board of a second type (referred to as "circuit board B"), wherein the circuit board B is or will be fitted with at least one electronic component with specific requirements, with the goal of creating a tiered circuit board combination, wherein the tiered circuit board combination is delimited at least in some areas by end portions formed by sections of the at least one circuit board A, and
positioning the resulting tiered circuit board combination on the heat sink such that a mounting side of the at least one circuit board B rests flat on a support surface of the heat sink, wherein the support surface of the heat sink is dimensioned and positioned such that it at least partially extends laterally beyond the mounting side of the at least one circuit board B in the respective directions of the end portions formed by the sections of the at least one circuit board A, and wherein support elements for mechanically supporting the end portions formed by the sections of the at least one circuit board A are designed on the support surface of the heat sink.

10. A method for producing an electronic module according to Claim 9, wherein the procedure comprises the steps:
a) providing at least one circuit board B with a component side (top) and a mounting side (bottom) facing away from the component side, as well as providing at least one electronic component with specific requirements,
b) placing (top-up) and fixing the at least one electronic component with specific requirements on the component side of the at least one circuit board B and subsequently turning over the circuit board B,
c) providing at least one circuit board A with a first component side (top) and a second component side (bottom) facing away from the first component side, as well as providing electronic component elements,
d) placing (top-up) and fixing electronic component elements on the first component side of the at least one printed circuit board A and subsequently turning over the printed circuit board A,
e) placing (bottom-up) and fixing electronic component elements on the second component side of the at least one circuit board A, as well as placing (bottom-up) and fixing the at least one fitted circuit board B from step b) on the second component side of the at least one circuit board A in an overlapping manner, for obtaining a tiered circuit board combination, wherein the tiered circuit board combination at least in some areas is delimited by end portions formed by sections of the at least one circuit board A, and
f) positioning the resulting tiered circuit board combination on the heat sink such that the mounting side of the at least one circuit board B rests flat on a support surface of the heat sink, wherein the support surface of the heat sink is dimensioned and positioned such that it at least partially extends laterally beyond the mounting side of the at least one circuit board B in the respective directions of the end portions formed by the sections of the at least one circuit board A, and wherein support elements for mechanically supporting the end portions formed by the sections of the at least one circuit board A are designed on the support surface of the heat sink.

11. A method for producing an electronic module according to Claim 9, wherein the procedure comprises the steps:
g) providing at least one circuit board A with a first component side (top) and a second component side (bottom) facing away from the first component side, as well as providing electronic component elements,
h) placing (bottom-up) and fixing electronic component elements on the second component side of the at least one circuit board A,
i) providing at least one circuit board B with a component side (top) and a mounting side facing away from the component side (bottom),
j) placing (bottom-up) and fixing the at least one circuit board B on the second component side of the at least one circuit board A in an overlapping manner, for obtaining a tiered circuit board combination, wherein the tiered circuit board combination at least in some areas is delimited by end portions formed by sections of the at least one circuit board A, and subsequently turning over the tiered circuit board combination,
k) placing (top-up) and fixing at least one provided electronic component with specific requirements on the component side of the at least one circuit board B, as well as placing and fixing electronic component elements on the first component side of the at least one circuit board B of the tiered circuit board combination from step j), for obtaining a tiered circuit board combination fitted with components on both sides, and
l) positioning the resulting tiered circuit board combination on the heat sink such that the mounting side of the at least one circuit board B rests flat on a support surface of the heat sink, wherein the support surface of the heat sink is dimensioned and positioned such that it at least partially extends laterally beyond the mounting side of the at least one circuit board B in the respective directions of the end portions formed by the sections of the at least one circuit board A, and such that support elements for mechanically supporting the end portions formed by the sections of the at least one circuit board A are designed on the support surface of the heat sink.

12. The method according to Claim 11, **characterized in that** the positioning of the at least one electronic component with specific requirements on the circuit board B from step k) is implemented with the help of reference marks positioned on the at least one circuit board A.

13. An electronic module (40) produced according to any one of Claims 9 to 12.

14. A lighting device for a motor vehicle, in particular motor vehicle headlamps, comprising an electronic module (40) according to any one of Claims 1 to 9 and 13.

15. A use of an electronic module according to any one of Claims 1 to 9 and 13 as or in a lighting device for a motor vehicle.

## Revendications

1. Module électronique (40) comprenant au moins une carte de circuits imprimés équipée le cas échéant des deux côtés d'une première catégorie (désignée en tant que « carte de circuits imprimés A »), qui est équipée d'une manière superposée d'au moins une carte de circuits imprimés d'une deuxième catégorie (désignée en tant que « carte de circuits imprimés B »), sachant que la carte de circuits imprimés B est équipée au moins d'un composant électronique avec des exigences (19) spécifiques et les cartes de circuits imprimés A et B reliées entre elles forment un composite étagé de cartes de circuits imprimés (100, 200, 300, 400, 500), sachant que le composite étagé de cartes de circuits imprimés (100, 200, 300, 400, 500) est limité au moins par endroits par des zones finales (16), lesquelles sont formées par des sections d'au moins une carte de circuits imprimés A et le composite étagé de cartes de circuits imprimés (100, 200, 300, 400, 500) est posé sur un dissipateur thermique (20), sachant qu'un côté de fixation (15) d'au moins une carte de circuits imprimés B repose sur toute la surface sur une surface d'appui (21) du dissipateur thermique (20), **caractérisé en ce que**
la surface d'appui (21) du dissipateur thermique (20) est dimensionnée et positionnée de telle manière qu'elle s'étend au moins par endroits latéralement au-delà du côté de fixation (15) d'au moins une carte de circuits imprimés B respectivement en direction des zones finales (16) formées par les sections d'au moins une carte de circuits imprimés A et **en ce que** sur la surface d'appui (21) du dissipateur thermique, des éléments de soutien (23, 24, 25, 26) sont constitués pour le soutien mécanique des zones finales (16) formées par les sections d'au moins une carte de circuits imprimés A.

2. Module électronique selon la revendication 1, **caractérisé en ce qu'**au moins une carte de circuits imprimés A comporte au moins un évidement (10) et **en ce qu'**au moins une carte de circuits imprimés B est reliée de manière superposée à au moins une carte de circuits imprimés A de telle manière qu'une carte de circuits imprimés B recouvre respectivement un évidement (10) de la carte de circuits imprimés A au moins par endroits, de préférence complètement.

3. Module électronique selon la revendication 1 ou 2, **caractérisé en ce qu'**au moins un évidement (10) est pour l'essentiel en forme de fenêtre.

4. Module électronique selon l'une quelconque des revendications 1 à 3, **caractérisé en ce que** les éléments de soutien (24, 25, 26) sont montés sur la surface d'appui (21) du dissipateur thermique (20) ou les éléments de soutien (23) sont conformés le cas échéant en une seule pièce sur la surface d'appui (21) du dissipateur thermique (20) et les éléments de soutien (21) sont agencés à cet effet pour soutenir les zones finales (16) formées par les sections d'au moins une carte de circuits imprimés A du composite de cartes de circuits imprimés (100, 200, 300, 400, 500).

5. Module électronique selon la revendication 4, **caractérisé en ce que** dans le secteur des zones finales (16) formées par les sections d'au moins une carte de circuits imprimés A du composite de cartes de circuits imprimés (100, 200, 300, 400, 500) sont montées sur la surface d'appui (21) du dissipateur thermique (20) des rondelles de calage (24, 26) dans un matériau de cartes de circuits imprimés B en tant qu'éléments de soutien et les zones finales (16) du composite de cartes de circuits imprimés (100, 200, 300, 400, 500) reposent sur les rondelles de calage (24, 26) et sont soutenues par celles-ci, sachant que le matériau de cartes de circuits imprimés B pour les rondelles de calage (24, 26) est choisi à partir de la même charge d'où provient le matériau de cartes de circuits imprimés B pour au moins une carte de circuits imprimés B.

6. Module électronique selon la revendication 5, **caractérisé en ce qu'**au moins une carte de circuits imprimés A comporte des trous d'orientation (22) et les rondelles de calage (26) sont positionnées en dessous des trous d'orientation d'au moins une carte de circuits imprimés A sur la surface d'appui du dissipateur thermique de telle manière que les zones de surface (26a) des rondelles de calage (26) respectives sont libérées par les trous d'orientation (22).

7. Module électronique selon l'une quelconque des revendications 1 à 6, **caractérisé en ce que** les éléments de soutien (23, 24, 25, 26) sont agencés pour évacuer l'énergie thermique d'au moins une carte de circuits imprimés A sur le dissipateur thermique et/ou pour permettre une compensation de potentiel entre au moins une carte de circuits imprimés A et le dissipateur thermique.

8. Module électronique selon l'une quelconque des revendications 1 à 7, **caractérisé en ce qu'**au moins une carte de circuits imprimés A et au moins une carte de circuits imprimés B sont en contact l'une avec l'autre dans leur zone de chevauchement (501) au moyen de la technique à matrice de billes (BGA).

9. Procédé de fabrication d'un module électronique dans une ligne d'équipement de composants, le module électronique comprenant un composite étagé de cartes de circuits imprimés avec au moins un composant électronique avec des exigences spécifiques et un dissipateur thermique, sachant que le procédé comprend :
l'équipement d'au moins une carte de circuits imprimés équipée ou à équiper le cas échéant des deux côtés d'une première catégorie (désignée en tant que « carte de circuits imprimés A ») d'une manière superposée avec au moins une carte de circuits imprimés d'une deuxième catégorie (désignée en tant que « carte de circuits imprimés B »), sachant que la carte de circuits imprimés B est équipée ou sera équipée d'au moins un composant électronique avec des exigences spécifiques pour obtenir un composite étagé de cartes de circuits imprimés, sachant que le composite étagé de cartes de circuits imprimés est limité au moins par endroits par des zones finales, lesquelles sont formées par des sections d'au moins une carte de circuits imprimés A, et
la pose du composite étage de cartes de circuits imprimés obtenu sur le dissipateur thermique de telle manière qu'un côté de fixation d'au moins une carte de circuits imprimés B repose sur toute la surface sur une surface d'appui du dissipateur thermique, sachant que la surface d'appui du dissipateur thermique est dimensionnée et positionnée de telle sorte qu'elle s'étend au moins en partie latéralement au-delà du côté de fixation d'au moins une carte de circuits imprimés B respectivement en direction des zones finales formées par les sections d'au moins une carte de circuits imprimés A et sachant que sur la surface d'appui du dissipateur thermique sont constitués des éléments de soutien pour le soutien mécanique des zones finales formées par les sections d'au moins une carte de circuits imprimés A.

10. Procédé de fabrication d'un module électronique selon la revendication 9, sachant que le procédé comprend les étapes de :
a) préparation d'au moins une carte de circuits imprimés B avec un côté d'équipement (haut) et un côté de fixation (bas) opposé au côté d'équipement ainsi que préparation d'au moins un composant électronique avec des exigences spécifiques,
b) équipement (en haut) et fixation d'au moins un composant électronique avec des exigences spécifiques sur le côté d'équipement d'au moins une carte de circuits imprimés B et ensuite retournement de la carte de circuits imprimés B,
c) préparation d'au moins une carte de circuits imprimés A avec un premier côté d'équipement (haut) et un deuxième côté d'équipement (bas) opposé au premier côté d'équipement ainsi que préparation des éléments électroniques de composant,
d) équipement (en haut) et fixation des éléments électroniques de composant sur le premier côté d'équipement d'au moins une carte de circuits imprimés A et ensuite retournement de la carte de circuits imprimés A,
e) équipement (de bas en haut)) et fixation des éléments électroniques de composant sur le deuxième côté d'équipement d'au moins une carte de circuits imprimés A ainsi qu'équipement (de bas en haut)) et fixation d'au moins une carte de circuits imprimés B équipé de l'étape b) sur le deuxième côté d'équipement d'au moins une carte de circuits imprimés A de manière superposée pour obtenir un composite étagé de cartes de circuits imprimés, sachant que le composite étage de cartes de circuits imprimés est limité au moins par endroits par des zones finales, lesquelles sont formées par des sections d'au moins une carte de circuits imprimés A,
f) pose du composite étagé obtenu de cartes de circuits imprimés sur le dissipateur thermique de telle manière que le côté de fixation d'au moins une carte de circuits imprimés B repose sur toute la surface sur une surface d'appui du dissipateur thermique, sachant que la surface d'appui du dissipateur thermique est dimensionnée et positionnée de telle sorte qu'elle s'étend au moins en partie latéralement au-delà du côté de fixation d'au moins une carte de circuits imprimés B respectivement en direction des zones finales formées par les sections d'au moins une carte de circuits imprimés A et sur la surface d'appui du dissipateur thermique sont constitués des éléments de soutien pour le soutien mécanique des zones finales formées par les sections d'au moins une carte de circuits imprimés A.

11. Procédé de fabrication d'un module électronique selon la revendication 9, sachant que le procédé comprend les étapes de :
g) préparation d'au moins une carte de circuits imprimés A avec un premier côté d'équipement (haut) et un deuxième côté d'équipement (bas) opposé au premier côté d'équipement ainsi que préparation d'éléments électroniques de composant,
h) équipement (de bas en haut)) et fixation d'éléments électroniques de composant sur le deuxième côté d'équipement d'au moins une carte de circuits imprimés A,
i) préparation d'au moins une carte de circuits imprimés B avec un côté d'équipement (haut) et d'un côté de fixation (bas) opposé au côté d'équipement,
j) équipement (de bas en haut)) et fixation d'au moins une carte de circuits imprimés B sur le deuxième côté d'équipement d'au moins une carte de circuits imprimés A de manière superposée pour obtenir un composite étagé de cartes de circuits imprimés, sachant que le composite étagé de cartes de circuits imprimés est limité au moins par endroits par des zones finales, lesquelles sont formées par des sections d'au moins une carte de circuits imprimés A et ensuite retournement du composite étagé de cartes de circuits imprimés,
k) équipement (en haut) et fixation d'au moins un composant électronique préparé avec des exigences spécifiques sur le côté d'équipement d'au moins une carte de circuits imprimés B ainsi que d'éléments électroniques de composant sur le premier côté d'équipement d'au moins une carte de circuits imprimés B du composite étagé de cartes de circuits imprimés de l'étape j), pour obtenir un composite étagé de cartes de circuits imprimés équipé des deux côtés, et
l) pose du composite étagé obtenu de cartes de circuits imprimés sur le dissipateur thermique de telle manière que le côté de fixation d'au moins une carte de circuits imprimés B repose sur toute la surface sur une surface d'appui du dissipateur thermique, sachant que la surface d'appui du dissipateur thermique est dimensionnée et positionnée de telle sorte qu'elle s'étend au moins en partie latéralement au-delà du côté de fixation d'au moins une carte de circuits imprimés B respectivement en direction des zones finales formées par les sections d'au moins une carte de circuits imprimés A et sur la surface d'appui du dissipateur thermique sont constitués des éléments de soutien pour le soutien mécanique des zones finales formées par les sections d'au moins une carte de circuits imprimés A.

12. Procédé selon la revendication 11, **caractérisé en ce que** dans l'étape k), le positionnement d'au moins un composant électronique avec des exigences spécifiques a lieu sur la carte de circuits imprimés B à l'aide des repères de référence positionnés sur au moins une carte de circuits imprimés A.

13. Module électronique (40) fabriqué selon l'une quelconque des revendications 9 à 12.

14. Dispositif d'éclairage pour un véhicule automobile, en particulier phare de véhicule automobile, comprenant un module électronique (40) selon l'une quelconque des revendications 1 à 9 et 13.

15. Utilisation d'un module électronique selon l'une quelconque des revendications 1 à 9 et 13 en tant que/ou dans un dispositif d'éclairage pour un véhicule automobile.
